# EUROPEAN PATENT APPLICATION

(11) **EP 4 692 940 A1**
(43) Date of publication of application: **11.02.2026**
(21) Application number: 24780137.6
(22) Date of filing: 25.03.2024
(51) Int. Cl.: G03F 7/075, C08L 83/12, C08L 101/00, G03F 7/004, G03F 7/16, G03F 7/023

(54) **PHOTOSENSITIVE RESIN COMPOSITION, CURED FILM, ELECTRONIC DEVICE, AND ELECTRONIC DEVICE MANUFACTURING METHOD**

(30) Priority: 30.03.2023 JP 2023055060
(71) Applicant: Sumitomo Bakelite Co., Ltd., Shinagawa-ku Tokyo 140-0002 (JP)
(72) Inventor: SUZUKI, Sakiko, Tokyo 140-0002 (JP); HIROSAWA, Ryuji, Tokyo 140-0002 (JP); HORII, Makoto, Tokyo 140-0002 (JP)
(74) Representative: Müller-Boré & Partner Patentanwälte PartG mbB
(86) International application number: PCT/JP2024/011610
(87) International publication number: WO 2024/204019

(57) **Abstract**

A photosensitive resin composition including an alkali-soluble resin (A); a polyether-modified polydimethylsiloxane (B); a solvent (C); and a photosensitizer (D), in which a polystyrene-equivalent weight-average molecular weight (Mw) of the polyether-modified polydimethylsiloxane (B), measured by gel permeation chromatography, is 1,000 or more and 5,000 or less.

## Description

### TECHNICAL FIELD

The present invention relates to a photosensitive resin composition, a cured film, an electronic device, and a method for manufacturing an electronic device.

### BACKGROUND ART

As a permanent film constituting an electronic device, a cured film obtained by exposing a photosensitive resin composition may be used. Examples of a technique related to such a photosensitive resin composition include the technique described in Patent Document 1.

Patent Document 1 has an object to provide a photosensitive resin composition having excellent chemical resistance while maintaining high sensitivity, and discloses a photosensitive resin composition including a polymer component including a polymer that includes (A) a polymer that satisfies at least one of the following (1) and (2): (1) a polymer having (a1) a constitutional unit having a residue in which an acid group is protected by an acid-decomposable group and (a2) a constitutional unit having a crosslinkable group; and (2) a polymer having (a1) a constitutional unit having a residue in which an acid group is protected by an acid-decomposable group and (a2) a constitutional unit having a crosslinkable group, (B) a photoacid generator, (C) an aromatic heterocyclic compound, and (D) a solvent, in which the (C) aromatic heterocyclic compound has a molecular weight of 1,000 or less, includes at least one nitrogen atom in an aromatic ring, and includes at least two coordinating atoms in the aromatic ring.

### RELATED DOCUMENT

### PATENT DOCUMENT

[Patent Document 1] Japanese Unexamined Patent Publication No. 2016-189006

### SUMMARY OF THE INVENTION

### TECHNICAL PROBLEM

The present invention provides a photosensitive resin composition having improved anti-foaming properties.

### SOLUTION TO PROBLEM

According to the present invention, there are provided a photosensitive resin composition, a cured film, an electronic device, and a method for manufacturing an electronic device, each shown below.
[1] A photosensitive resin composition including:
   an alkali-soluble resin (A);
   a polyether-modified polydimethylsiloxane (B);
   a solvent (C); and
   a photosensitizer (D),
   in which a polystyrene-equivalent weight-average molecular weight (Mw) of the polyether-modified polydimethylsiloxane (B), measured by gel permeation chromatography, is 1,000 or more and 5,000 or less.
[2] The photosensitive resin composition according to [1],
   in which the solvent (C) includes a solvent (C1), and
   the solvent (C1) includes at least one selected from the group consisting of γ-butyrolactone, N-methyl-2-pyrrolidone, N-ethyl-2-pyrrolidone, propylene glycol monomethyl ether, 3-methyl-2-oxazolidinone, 3-methoxy-N,N-dimethylpropanamide, and propylene glycol monomethyl ether acetate.
[3] The photosensitive resin composition according to [2],
   in which a content of the solvent (C1) in the solvent (C) is 50% by mass or more and 100% by mass or less with respect to an entirety of the solvent (C).
[4] The photosensitive resin composition according to any one of [1] to [3],
   in which the polyether-modified polydimethylsiloxane (B) includes a polyether-modified polydimethylsiloxane having a ratio (Mw/Mn) of a polystyrene-equivalent weight-average molecular weight (Mw) to a polystyrene-equivalent number-average molecular weight (Mn), measured by gel permeation chromatography, of 1 or more and 10 or less.
[5] The photosensitive resin composition according to any one of [1] to [4],
   in which the polyether-modified polydimethylsiloxane (B) includes a polyether-modified polydimethylsiloxane having a weight-average molecular weight of a maximum peak of a polystyrene-equivalent molecular weight distribution, measured by gel permeation chromatography, of 1,000 or more and 5,000 or less.
[6] The photosensitive resin composition according to any one of [1] to [5],
   in which a polystyrene-equivalent weight-average molecular weight (Mw) of the alkali-soluble resin (A), measured by gel permeation chromatography, is 5,000 or more and 70,000 or less.
[7] The photosensitive resin composition according to any one of [1] to [6],
   in which a content of the polyether-modified polydimethylsiloxane (B) is 10 ppm or more and 3,000 ppm or less with respect to an entirety of the photosensitive resin composition.
[8] The photosensitive resin composition according to any one of [1] to [7], further including:
   an adhesion aid (E).
[9] The photosensitive resin composition according to any one of [1] to [8],
   in which the polyether-modified polydimethylsiloxane (B) includes a polyether-modified polydimethylsiloxane represented by General Formula (1), 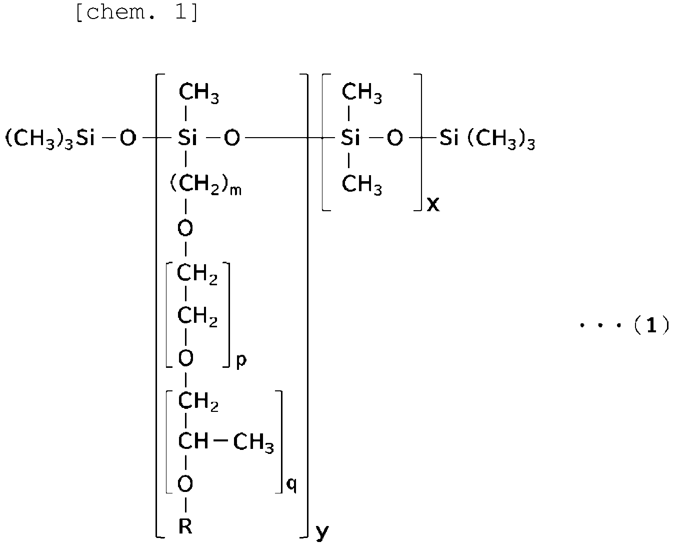
   (in General Formula (1), m has an average value of 1 or more and 5 or less, p has an average value of 1 or more and 10 or less, q has an average value of 0 or more and less than 1, and R represents hydrogen or an alkyl group having 1 or more and 5 or less carbon atoms).
[10] The photosensitive resin composition according to [9],
   in which in General Formula (1), x has an average value of 1 or more and 50 or less, and y has an average value of 1 or more and 10 or less.
[11] The photosensitive resin composition according to [9] or [10],
   in which x/y in General Formula (1) is 1 or more and 5 or less.
[12] A cured film obtained by curing the photosensitive resin composition according to any one of [1] to [11].
[13] An electronic device including:
   the cured film according to [12].
[14] A method for manufacturing an electronic device, the method including:
   a step of forming a coating film over a substrate using the photosensitive resin composition according to any one of [1] to [11].
[15] The method for manufacturing an electronic device according to [14], the method further including:
   a step of washing the coating film on a back side of the substrate.

### ADVANTAGEOUS EFFECTS OF INVENTION

According to the present invention, it is possible to provide a photosensitive resin composition having improved anti-foaming properties.

### BRIEF DESCRIPTION OF THE DRAWINGS

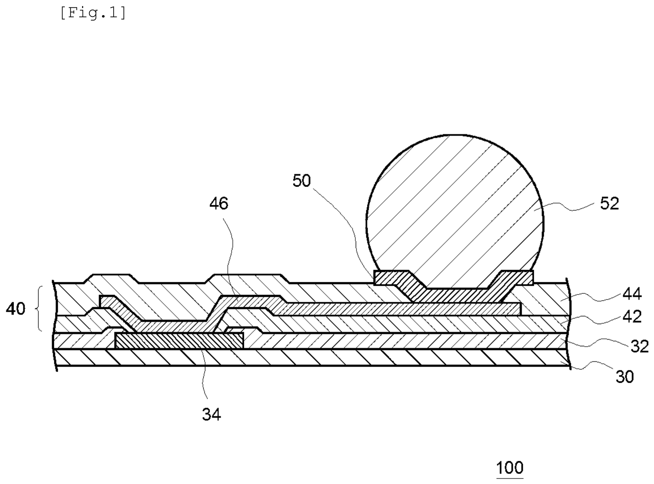

Fig. 1 is a view showing an example of an electronic device including a photosensitive resin composition of the present embodiment.

### DESCRIPTION OF EMBODIMENTS

Hereinafter, embodiments of the present invention will be described in detail. Furthermore, in the present specification, the notation "a to b" in the description of the numerical range indicates "equal to or more than a and equal to or less than b" unless otherwise specified.

The photosensitive resin composition of the present embodiment includes an alkali-soluble resin (A), a polyether-modified polydimethylsiloxane (B), a solvent (C), and a photosensitizer (D), in which a polystyrene-equivalent weight-average molecular weight (Mw) of the polyether-modified polydimethylsiloxane (B), measured by gel permeation chromatography, is 1,000 or more and 5,000 or less.

In the polyether-modified polydimethylsiloxane (B) of the present embodiment, from the viewpoint of further improving the anti-foaming properties and further improving the affinity for an aqueous solvent, a polystyrene-equivalent weight-average molecular weight (Mw), measured by gel permeation chromatography, is 1,000 or more, preferably 1,200 or more, more preferably 1,300 or more, and still more preferably 1,400 or more, and from the viewpoint of further improving the anti-foaming properties, the Mw is 5,000 or less, preferably 4,000 or less, more preferably 3,000 or less, still more preferably 2,500 or less, and even still more preferably 2,000 or less.

In addition, in the polyether-modified polydimethylsiloxane (B) of the embodiment, from the viewpoint of further improving the anti-foaming properties and further improving the affinity for an aqueous solvent, the polystyrene-equivalent weight-average molecular weight (Mw), measured by gel permeation chromatography, is 1,000 or more and 5,000 or less, preferably 1,200 or more and 4,000 or less, more preferably 1,300 or more and 3,000 or less, still more preferably 1,400 or more and 2,500 or less, and even still more preferably 1,400 or more and 2,000 or less.

The polyether-modified polydimethylsiloxane (B) can be used alone or in combination of two or more kinds thereof. In a case where two or more kinds of the polyether-modified polydimethylsiloxanes (B) are used, the weight-average molecular weight (Mw) of one kind of the polyether-modified polydimethylsiloxane (B) only needs to be within the range, but it is preferable that the weight-average value of the weight-average molecular weights (Mw) of the polyether-modified polydimethylsiloxane (B) is within the range.

In the present embodiment, the weight-average molecular weight (Mw) of the polyether-modified polydimethylsiloxane (B) can be calculated using a molecular weight distribution curve obtained by gel permeation chromatography (GPC). The weight-average molecular weight (Mw) of the polyether-modified polydimethylsiloxane (B) is calculated using a polystyrene-equivalent value determined from a calibration curve of standard polystyrene (PS) obtained by GPC measurement.

The measurement conditions of GPC are, for example, as follows.
Device: Gel permeation chromatography device HLC-8320GPC manufactured by Tosoh Corporation
Column: TSK-GEL Supermultipore HZ-M manufactured by Tosoh Corporation
Detector: RI detector for liquid chromatogram
Measurement temperature: 40°C
Solvent: THF
Flow rate: 0.35 mL/min
Sample concentration in measurement solution: 2.0 mg/mL

The demands for cured films used in electronic devices are increasing. For example, in a case of producing a cured film, voids, defects, and the like may occur in the obtained cured film due to foams generated in a case of producing a photosensitive resin composition, which may result in a decrease in productivity of the cured film or a decrease in reliability of an electronic device. That is, the photosensitive resin composition is required to improve the anti-foaming properties. In addition, since a fluorine-based surfactant is used as a surfactant in a photosensitive resin composition in the related art, a use thereof is limited from the viewpoint of environmental load.

By configuring the photosensitive resin composition of the present embodiment to include the alkali-soluble resin (A), the polyether-modified polydimethylsiloxane (B), the solvent (C), and the photosensitizer (D), in which the weight-average molecular weight (Mw) of the polyether-modified polydimethylsiloxane (B) is within the range, it is possible to improve the anti-foaming properties of the photosensitive resin composition while reducing the amount of the fluorine-based surfactant used.

A reason for this is not clear, but it is considered that since the weight-average molecular weight (Mw) of the polyether-modified polydimethylsiloxane (B) is within an appropriate range, the compatibility between the polyether-modified polydimethylsiloxane (B) and the solvent (C) is improved and the stability of foams is lowered, whereby the anti-foaming properties of the photosensitive resin composition are improved. In addition, it is considered that the polyether-modified polydimethylsiloxane (B) is appropriately non-polar due to the presence of a polyether-modified group, and the stability of foams is thus lowered, whereby the anti-foaming properties of the photosensitive resin composition are improved.

Hereinafter, each component of the photosensitive resin composition according to the present embodiment will be described.

### (Alkali-Soluble Resin (A))

The alkali-soluble resin (A) can be selected according to physical properties such as mechanical properties and optical properties, required for the resin film. Specific examples of the alkali-soluble resin (A) include a polyamide resin, a polybenzoxazole resin, a polyimide resin, a phenol resin, a hydroxystyrene resin, and a cyclic olefin resin, and one kind or a combination of two or more kinds of these resins can be used. The alkali-soluble resin (A) preferably includes one, or two or more selected from the group consisting of the polyamide resin and the polybenzoxazole resin, and more preferably includes the polybenzoxazole resin, among those specific examples. This makes it possible to further improve the dispersibility of the alkali-soluble resin (A) in the photosensitive resin composition. In addition, by further improving physical properties such as mechanical strength, of the cured film consisting of the photosensitive resin composition, the uniformity of the film thickness can be improved and the occurrence of defects can be further suppressed.

### (Polyamide Resin and Polybenzoxazole Resin)

The polyamide resin preferably includes an aromatic polyamide including an aromatic ring in a structural unit of a polyamide, and more preferably includes a structural unit represented by Formula (PA1). This makes it possible to further improve the physical properties such as the mechanical strength, of the cured film consisting of the photosensitive resin composition. Thus, the uniformity of the film thickness can be further improved and the occurrence of defects can be further suppressed.

Furthermore, in the present embodiment, the aromatic ring indicates a benzene ring; a fused aromatic ring such as a naphthalene ring, an anthracene ring, and a pyrene ring; a heteroaromatic ring such as a pyridine ring and a pyrrole ring. From the viewpoint of further improving the mechanical strength, the polyamide resin of the present embodiment preferably includes the benzene ring as an aromatic ring.

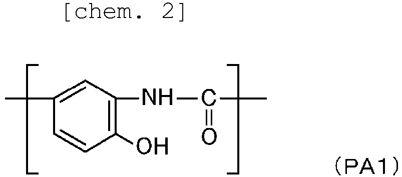

The polyamide resin including the structural unit represented by Formula (PA1) is a precursor of a polybenzoxazole resin. The polyamide resin including the structural unit represented by Formula (PA1) can be subjected to a heat treatment at a temperature of 150°C or higher and 420°C or lower for a period of time of 30 minutes or longer and 50 hours or shorter to undergo dehydrative ring closure, thereby obtaining a polybenzoxazole resin. Here, the structural unit of Formula (PA1) is a structural unit represented by Formula (PBO1) by dehydrative ring closure.

In a case where the alkali-soluble resin (A) according to the present embodiment includes a polyamide resin including the structural unit represented by Formula (PA1), for example, the photosensitive resin composition can be subjected to the heat treatment to make the polyamide resin undergo dehydrative ring closure, thereby obtaining a polybenzoxazole resin. That is, in a case where the photosensitive resin composition including a polyamide resin is subjected to the heat treatment, the photosensitive resin composition includes a polybenzoxazole resin.

In addition, in a case where the alkali-soluble resin (A) includes the polyamide resin including the structural unit represented by Formula (PA1), the polyamide resin may be subjected to the heat treatment after manufacturing a cured film described later, to undergo dehydrative ring closure, thereby obtaining a polybenzoxazole resin. In a case where the polyamide resin is subjected to dehydrative ring opening to form a polybenzoxazole resin, the mechanical properties and the thermal properties can be further improved, and deformation of the cured film can be further suppressed.

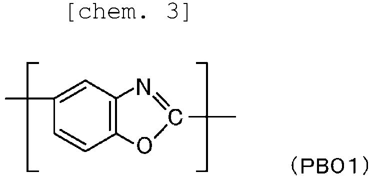

### (Polyamide Resin and Polyimide Resin)

In addition, as the polyamide resin, for example, a polyamide resin including a structural unit represented by Formula (PA2) may be used.

The polyamide resin including a structural unit represented by Formula (PA2) is a precursor of a polyimide resin. The polyamide resin including the structural unit represented by Formula (PA2) can be subjected to a heat treatment at a temperature of 150°C or higher and 420°C or lower for a period of time of 30 minutes or longer and 50 hours or shorter to undergo dehydrative ring closure, thereby obtaining a polyimide resin. Here, the structural unit of Formula (PA2) serves as a structural unit represented by Formula (PI1) by dehydrative ring closure.

In a case where the alkali-soluble resin (A) according to the present embodiment is the polyamide resin including the structural unit represented by Formula (PA2), the photosensitive resin composition may be subjected to the heat treatment to undergo dehydrative ring closure, thereby obtaining a polyimide resin. That is, the photosensitive resin composition which has been subjected to the heat treatment includes a polyimide resin which is the alkali-soluble resin (A).

In addition, in a case where the alkali-soluble resin (A) includes the polyamide resin including a structural unit represented by Formula (PA2), a resin film and an electronic device, described later, may be manufactured, and then subjected to the heat treatment to undergo dehydrative ring closure, thereby obtaining a polyimide resin.

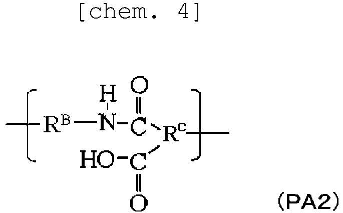

In Formula (PA2), R^{B} and R^{C} are each independently preferably an organic group having 1 or more and 30 or less carbon atoms. 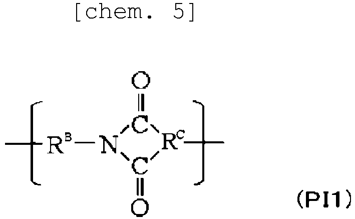 In Formula (PI1), R^{B} and R^{C} are the same as those in Formula (PA2) .

R^{B} and R^{C} in Formula (PA2) and Formula (PI1) are each preferably an organic group having an aromatic ring.

The organic group having an aromatic ring preferably includes a benzene ring, a naphthalene ring, or an anthracene ring, and more preferably includes the benzene ring. This makes it possible to further improve the dispersibility of the alkali-soluble resin (A) and to further improve the anti-foaming properties of the photosensitive resin composition.

### (Method for Producing Polyamide Resin)

The polyamide resin can be polymerized, for example, as follows.

First, in the polymerization step (S1), a diamine monomer and a dicarboxylic acid monomer are polycondensed to polymerize a polyamide. Next, the low-molecular-weight component is removed by the low-molecular-weight component removing step (S2) to obtain a polyamide resin including the polyamide as a main component.

### (Polymerization Step (S1))

In the polymerization step (S1), the diamine monomer and the dicarboxylic acid monomer are polycondensed. The polycondensation method for polymerizing the polyamide is not limited, and specific examples thereof include melt polycondensation, an acid chloride method, and direct polycondensation.

Furthermore, a compound selected from the group consisting of a tetracarboxylic dianhydride, a trimellitic anhydride, a dicarboxylic dichloride, and an active ester-type dicarboxylic acid may be used instead of the dicarboxylic acid monomer. Specific examples of the method for obtaining the active ester-type dicarboxylic acid include a method of reacting the dicarboxylic acid with 1-hydroxy-1,2,3-benzotriazole.

The diamine monomer and the dicarboxylic acid monomer used for the polymerization of the polyamide resin will be described below. Furthermore, one kind of diamine monomer and one kind of dicarboxylic acid monomer may be used, or one, or two or more selected from the group consisting of two or more kinds of diamine monomers and two or more kinds of dicarboxylic acid monomers may be used.

### (Diamine Monomer)

As the diamine monomer used for polymerization, a diamine monomer including an aromatic ring in the structure is preferably used, and a diamine monomer including a phenolic hydroxyl group in the structure is more preferably used. By producing a polyamide resin using such a diamine monomer as a raw material, the conformation of the polyamide resin can be controlled and the dispersibility of the alkali-soluble resin (A) in the photosensitive resin composition can be further improved.

The diamine monomer including a phenolic hydroxyl group in the structure is preferably a diamine monomer represented by Formula (DA1). By producing a polyamide resin using such a diamine monomer as a raw material, the conformation of the polyamide resin can be controlled and the molecular chains of the polyamide resin can form a denser structure. Therefore, it is considered that the molecular structure can be frozen in a coordination in which the molecules of the alkali-soluble resin (A) and the metal molecules are more strongly bonded, and the adhesiveness with the substrate can be further improved.

Furthermore, for example, in a case where the diamine monomer represented by Formula (DA1) is used, the polyamide resin preferably includes a structural unit represented by Formula (PA3).

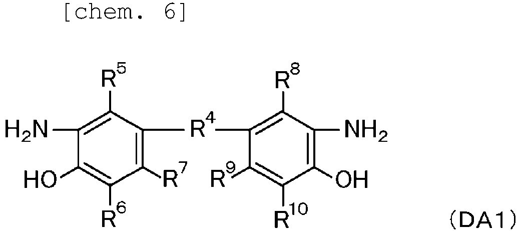

In Formula (DA1), R⁴ is preferably a group formed of one kind or two or more kinds of atoms selected from the group consisting of a hydrogen atom, a carbon atom, an oxygen atom, a nitrogen atom, a sulfur atom, a phosphorus atom, a silicon atom, a chlorine atom, a fluorine atom, and a bromine atom. R⁵ to R¹⁰ preferably each independently represent a hydrogen atom or an organic group having 1 or more and 30 or less carbon atoms.

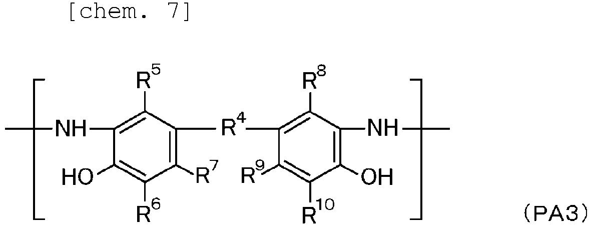

In Formula (PA3), R⁵ to R¹⁰ are the same as those in Formula (DA1) .

R⁴ in Formula (DA1) and Formula (PA3) is preferably a group formed of one kind or two or more kinds of atoms selected from the group consisting of a hydrogen atom, a carbon atom, an oxygen atom, a nitrogen atom, a sulfur atom, a phosphorus atom, a silicon atom, a chlorine atom, a fluorine atom, and a bromine atom.

Furthermore, R⁴ is preferably a divalent group. Here, the divalent group indicates an atomic valence. That is, it indicates that the number of bonds in which R⁴ is bonded to another atom is 2.

In a case where R⁴ in Formula (DA1) and Formula (PA3) includes a carbon atom, R⁴ is preferably a group having 1 or more and 30 or less carbon atoms, more preferably a group having 1 or more and 10 or less carbon atoms, still more preferably a group having 1 or more and 5 or less carbon atoms, and even still more preferably a group having 1 or more and 3 or less carbon atoms.

In a case where R⁴ in Formula (DA1) and Formula (PA3) includes a carbon atom, specific examples of R⁴ include an alkylene group, an arylene group, a halogen-substituted alkylene group, and a halogen-substituted arylene group.

The alkylene group may be, for example, a linear alkylene group or a branched alkylene group. Specific examples of the linear alkylene group include a methylene group, an ethylene group, a propylene group, a butylene group, a pentylene group, a hexylene group, a heptylene group, an octylene group, a nonylene group, a decanylene group, a trimethylene group, a tetramethylene group, a pentamethylene group, and a hexamethylene group. Specific examples of the branched alkylene group include alkylmethylene groups such as -C(CH₃)₂-, -CH(CH₃)-, -CH(CH₂CH₃)-, -C(CH₃)(CH₂CH₃)-, -C(CH₃)(CH₂CH₂CH₃)-, and - C(CH₂CH₃)₂-, and alkylethylene groups such as -CH(CH₃)CH₂-, - CH(CH₃)CH(CH₃)-, -C(CH₃)₂CH₂-, -CH(CH₂CH₃)CH₂-, and -C(CH₂CH₃)₂-CH₂-.

Specific examples of the arylene group include a phenylene group, a biphenylene group, a naphthylene group, an anthrylene group, and a group in which two or more arylene groups are bonded to each other.

As the halogen-substituted alkylene group and the halogen-substituted arylene group, each of those in which a hydrogen atom in the above-described alkylene group and arylene group has been substituted with a halogen atom such as a fluorine atom, a chlorine atom, and a bromine atom can be preferably used. Among these, those in which the hydrogen atom is substituted with the fluorine atom are preferably used.

In a case where R⁴ in Formula (DA1) and Formula (PA3) does not include a carbon atom, specific examples of R⁴ include a group consisting of an oxygen atom or a sulfur atom.

R⁵ to R¹⁰ in Formula (DA1) and Formula (PA3) are each independently preferably a hydrogen atom or an organic group having 1 or more and 30 or less carbon atoms, preferably the hydrogen atom or an organic group having 1 or more and 10 or less carbon atoms, more preferably the hydrogen atom or an organic group having 1 or more and 5 or less carbon atoms, still more preferably the hydrogen atom or an organic group having 1 or more and 3 or less carbon atoms, and even still more preferably the hydrogen atom or an organic group having 1 or more and 2 or less carbon atoms. This makes it possible for the aromatic rings of the polyamide resin to be closely arranged. Therefore, the molecular structure can be frozen in a coordination in which the molecule of the alkali-soluble resin (A) and the metal molecule are more strongly bonded, and the adhesiveness can be further improved.

Specific examples of the organic group having 1 or more and 30 or less carbon atoms as R⁵ to R¹⁰ in Formula (DA1) and Formula (PA3) include alkyl groups such as a methyl group, an ethyl group, an n-propyl group, an isopropyl group, an n-butyl group, an isobutyl group, a sec-butyl group, a tert-butyl group, a pentyl group, a neopentyl group, a hexyl group, a heptyl group, an octyl group, a nonyl group, and a decyl group; alkenyl groups such as an allyl group, a pentenyl group, and a vinyl group; alkynyl groups such as an ethynyl group; alkylidene groups such as a methylidene group and an ethylidene group; aryl groups such as a tolyl group, a xylyl group, a phenyl group, a naphthyl group, and an anthracenyl group; aralkyl groups such as a benzyl group and a phenethyl group; cycloalkyl groups such as an adamantyl group, a cyclopentyl group, a cyclohexyl group, and a cyclooctyl group; and alkaryl groups such as a tolyl group and a xylyl group.

As the diamine monomer represented by Formula (DA1), one, or two or more selected from the group consisting of 2,2-bis(3-amino-4-hydroxyphenyl)hexafluoropropane, 4,4'-methylenebis(2-amino-3,6-dimethylphenol), 4,4'-methylenebis(2-aminophenol), 1,1-bis(3-amino 4-hydroxyphenyl)ethane, and 3,3'-diamino-4,4'-dihydroxydiphenyl ether is preferably used. The use of these diamine monomers makes it possible for the aromatic rings of the polyamide resin to be closely arranged. Therefore, the molecular structure can be frozen in a coordination in which the molecule of the alkali-soluble resin (A) and the metal molecule are more strongly bonded, and the adhesiveness can be further improved. Furthermore, as the diamine monomer, one kind or a combination of two or more kinds of diamine monomers among the specific examples can be used.

The structural formulae of these diamine monomers are shown below.

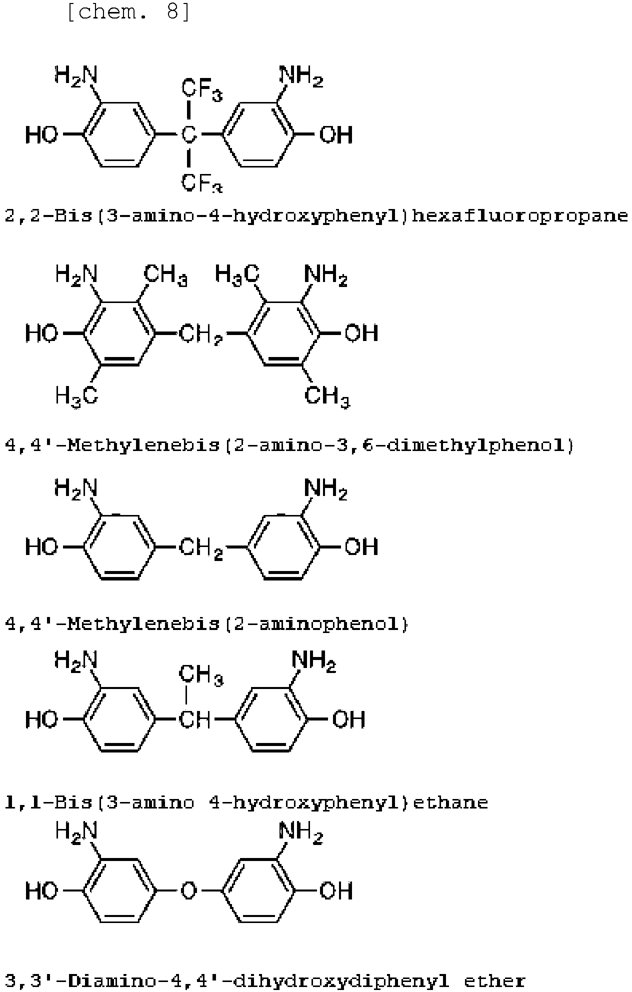

### (Dicarboxylic Acid Monomer)

As the dicarboxylic acid monomer used for polymerization, a dicarboxylic acid monomer including an aromatic ring in the structure is preferably used. As the dicarboxylic acid monomer including an aromatic ring, a dicarboxylic acid monomer represented by Formula (DC1) is preferably used. By producing a polyamide resin using such a dicarboxylic acid monomer as a raw material, the conformation of the polyamide resin can be controlled and the dispersibility of the alkali-soluble resin (A) in a mixed solvent can be further improved. In addition, due to the improvement of the dispersibility of the alkali-soluble resin (A), the anti-foaming properties of the photosensitive resin composition can be further improved.

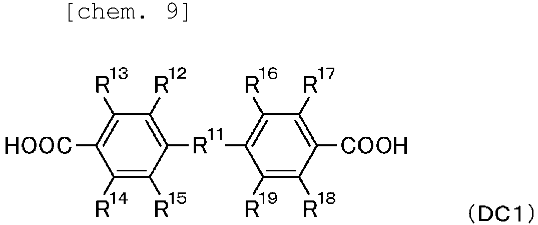

In Formula (DC1), R¹¹ is preferably a group formed of one kind or two or more kinds of atoms selected from the group consisting of a hydrogen atom, a carbon atom, an oxygen atom, a nitrogen atom, a sulfur atom, a phosphorus atom, a silicon atom, a chlorine atom, a fluorine atom, and a bromine atom. R¹² to R¹⁹ preferably each independently represent a hydrogen atom or an organic group having 1 or more and 30 or less carbon atoms.

Furthermore, for example, in a case where the dicarboxylic acid monomer represented by Formula (DC1) is used, the polyamide resin typically includes a structural unit represented by Formula (PA4). In addition, in Formula (PA4), the definitions of R¹¹ and R¹² to R¹⁹ are the same as those in Formula (DC1).

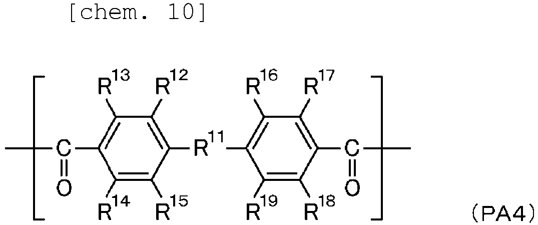

R¹¹ in Formula (DC1) and Formula (PA4) is preferably a group formed of one kind or two or more kinds of atoms selected from the group consisting of a hydrogen atom, a carbon atom, an oxygen atom, a nitrogen atom, a sulfur atom, a phosphorus atom, a silicon atom, a chlorine atom, a fluorine atom, and a bromine atom.

Furthermore, R¹¹ is preferably a divalent group. Here, the divalent group indicates an atomic valence. That is, it indicates that the number of bonds in which R¹¹ is bonded to another atom is 2.

In a case where R¹¹ in Formula (DC1) and Formula (PA4) includes a carbon atom, R¹¹ is preferably a group having 1 or more and 30 or less carbon atoms, more preferably a group having 1 or more and 10 or less carbon atoms, still more preferably a group having 1 or more and 5 or less carbon atoms, and even still more preferably a group having 1 or more and 3 or less carbon atoms.

In a case where R¹¹ in Formula (DC1) and Formula (PA4) includes a carbon atom, specific examples of R¹¹ include an alkylene group, an arylene group, a halogen-substituted alkylene group, and a halogen-substituted arylene group.

The alkylene group may be, for example, a linear alkylene group or a branched alkylene group. Specific examples of the linear alkylene group include a methylene group, an ethylene group, a propylene group, a butylene group, a pentylene group, a hexylene group, a heptylene group, an octylene group, a nonylene group, a decanylene group, a trimethylene group, a tetramethylene group, a pentamethylene group, and a hexamethylene group. Specific examples of the branched alkylene group include alkylmethylene groups such as -C(CH₃)₂-, -CH(CH₃)-, -CH(CH₂CH₃)-, -C(CH₃)(CH₂CH₃)-, -C(CH₃)(CH₂CH₂CH₃)-, and - C(CH₂CH₃)₂-, and alkylethylene groups such as -CH(CH₃)CH₂-, - CH(CH₃)CH(CH₃)-, -C(CH₃)₂CH₂-, -CH(CH₂CH₃)CH₂-, and -C(CH₂CH₃)₂-CH₂-.

Specific examples of the arylene group include a phenylene group, a biphenylene group, a naphthylene group, an anthrylene group, and a group in which two or more arylene groups are bonded to each other.

As the halogen-substituted alkylene group and the halogen-substituted arylene group, specifically, each of those in which a hydrogen atom in the above-described alkylene group and arylene group has been substituted with a halogen atom such as a fluorine atom, a chlorine atom, and a bromine atom can be used. Among these, those in which the hydrogen atom is substituted with the fluorine atom are preferably used.

In a case where R¹¹ in Formula (DC1) and Formula (PA4) does not include a carbon atom, specific examples of R¹¹ include a group consisting of an oxygen atom or a sulfur atom.

R¹² to R¹⁹ in Formula (DC1) and Formula (PA4) are each independently preferably a hydrogen atom or an organic group having 1 or more and 30 or less carbon atoms, preferably the hydrogen atom or an organic group having 1 or more and 10 or less carbon atoms, more preferably the hydrogen atom or an organic group having 1 or more and 5 or less carbon atoms, still more preferably the hydrogen atom or an organic group having 1 or more and 3 or less carbon atoms, and even still more preferably the hydrogen atom.

Specific examples of the organic group having 1 or more and 30 or less carbon atoms as R¹² to R¹⁹ in Formula (DC1) and Formula (PA4) include alkyl groups such as a methyl group, an ethyl group, an n-propyl group, an isopropyl group, an n-butyl group, an isobutyl group, a sec-butyl group, a tert-butyl group, a pentyl group, a neopentyl group, a hexyl group, a heptyl group, an octyl group, a nonyl group, and a decyl group; alkenyl groups such as an allyl group, a pentenyl group, and a vinyl group; alkynyl groups such as an ethynyl group; alkylidene groups such as a methylidene group and an ethylidene group; aryl groups such as a tolyl group, a xylyl group, a phenyl group, a naphthyl group, and an anthracenyl group; aralkyl groups such as a benzyl group and a phenethyl group; cycloalkyl groups such as an adamantyl group, a cyclopentyl group, a cyclohexyl group, and a cyclooctyl group; and alkaryl groups such as a tolyl group and a xylyl group.

As the dicarboxylic acid monomer, specifically, diphenyl ether 4,4'-dicarboxylic acid, isophthalic acid, terephthalic acid, 4,4'-biphenyldicarboxylic acid, or the like can be used. As the dicarboxylic acid monomer, among the specific examples, diphenyl ether 4,4'-dicarboxylic acid or isophthalic acid is preferably used, and diphenyl ether 4,4'-dicarboxylic acid is more preferably used. This makes it possible for the aromatic rings of the polyamide resin to be closely arranged. Therefore, the molecular structure can be frozen in a coordination in which the molecule of the alkali-soluble resin (A) and the metal molecule are more strongly bonded, and the adhesiveness can be further improved.

Furthermore, it is preferable to modify the amino group present at a terminal of the polyamide resin at the same time as the polymerization step (S1) or after the polymerization step (S1). The modification can be performed, for example, by reacting a specific acid anhydride or a specific monocarboxylic acid with a diamine monomer or a polyamide resin. Therefore, the polyamide resin preferably has the terminal amino group modified with a specific acid anhydride or a specific monocarboxylic acid. Furthermore, the specific acid anhydride and the specific monocarboxylic acid each have one or more functional groups selected from the group consisting of an alkenyl group, an alkynyl group, and a hydroxyl group. In addition, the specific acid anhydride and the specific monocarboxylic acid are preferably those including a nitrogen atom. This makes it possible to further improve the wettability between the photosensitive resin composition after post-baking and the metal.

Specific examples of the specific acid anhydride include maleic anhydride, citraconic anhydride, 2,3-dimethylmaleic anhydride, 4-cyclohexene-1,2-dicarboxylic anhydride, exo-3,6-epoxy-1,2,3,6-tetrahydrophthalic anhydride, 5-norbornene-2,3-dicarboxylic anhydride, methyl-5-norbornene-2,3-dicarboxylic anhydride, itaconic anhydride, het anhydride, 4-ethynylphthalic anhydride, 4-phenylethynylphthalic anhydride, and 4-hydroxyphthalic anhydride. As the specific acid anhydride, one kind or a combination of two or more kinds of specific acid anhydrides among the specific examples can be used.

Furthermore, in a case where an amino group present at a terminal of the polyamide resin is modified with a specific cyclic acid anhydride, the specific cyclic acid anhydride undergoes ring opening. Here, after modifying the polyamide resin, a structural unit derived from the specific cyclic acid anhydride is subjected to ring closure to form an imide ring. Examples of the method for the ring closure include a heat treatment.

In addition, specific examples of the specific monocarboxylic acid include 5-norbornene-2-carboxylic acid, 4-hydroxybenzoic acid, and 3-hydroxybenzoic acid. As the specific monocarboxylic acid, one kind or a combination of two or more kinds of specific monocarboxylic acids among the specific examples can be used.

In addition, the carboxyl group present at a terminal of the polyamide resin may be modified at the same time as the polymerization step (S1) or after the polymerization step (S1). The modification can be performed, for example, by reacting a specific nitrogen atom-containing heteroaromatic compound with a dicarboxylic acid monomer or a polyamide resin. Therefore, it is preferable that the polyamide resin is obtained by modifying a terminal carboxyl group with a specific nitrogen atom-containing heteroaromatic compound. Furthermore, the specific nitrogen atom-containing heteroaromatic compound is a compound having one or more functional groups consisting of a group consisting of a 1-(5-1H-triazoyl)methylamino group, a 3-(1H-pyrazoyl)amino group, a 4-(1H-pyrazoyl)amino group, a 5-(1H-pyrazoyl)amino group, a 1-(3-1H-pyrazoyl)methylamino group, a 1-(4-1H-pyrazoyl)methylamino group, a 1-(5-1H-pyrazoyl)methylamino group, a (1H-tetrazol-5-yl)amino group, a 1-(1H-tetrazol-5-yl)methyl-amino group, and a 3-(1H-tetrazol-5-yl)benzenamino group. This makes it possible to increase the number of isolated electron pairs in the photosensitive resin composition. Therefore, the wettability between the photosensitive resin composition after pre-baking and post-baking and the metal can be further improved.

Specific examples of the specific nitrogen atom-containing heteroaromatic compound include 5-aminotetrazole.

### (Low-Molecular-Weight Component Removing Step (S2))

It is preferable that the low-molecular-weight component removing step (S2) is performed after the polymerization step (S1) to remove the low-molecular-weight component.

Specifically, an organic layer including a mixture of a low-molecular-weight component and a polyamide resin is concentrated by filtration or the like and then dissolved again in an organic solvent such as water/isopropanol. This makes it possible to obtain a polyamide resin from which the low-molecular-weight component has been removed by filtering the precipitate.

Furthermore, with regard to the polyamide resin, it is preferable to prepare a photosensitive resin composition in the form of a varnish without going through a step in which the solvent is completely volatilized and dried, for example, after the low-molecular-weight component removing step. This makes it possible to further suppress the decrease in the dispersibility of the alkali-soluble resin (A) due to the interaction derived from the amide bond between the molecules of the polyamide resin. Therefore, the anti-foaming properties of the photosensitive resin composition can be further improved.

### (Phenol Resin)

Specific examples of the phenol resin include novolak-type phenol resins such as a phenol novolak resin, a cresol novolak resin, a bisphenol novolak resin, and a phenol-biphenyl novolak resin; a reactant of a phenol compound and an aldehyde compound, such as a novolak-type phenol resin, a resol-type phenol resin, and a cresol novolak resin; and a reactant of a phenol compound and a dimethanol compound, such as a phenol aralkyl resin. Furthermore, as the phenol resin, one kind or two or more kinds of phenol resins among the specific examples can be included.

The phenol compound used in the above-described reactant of the phenol compound and the aldehyde compound or the above-described reactant of a phenol compound and a dimethanol compound is not limited.

Specific examples of such a phenol compound include cresols such as phenol, o-cresol, m-cresol, and p-cresol; xylenols such as 2,3-xylenol, 2,4-xylenol, 2,5-xylenol, 2,6-xylenol, 3,4-xylenol, and 3,5-xylenol; ethylphenols such as o-ethylphenol, methylphenol, and p-ethylphenol; alkylphenols such as isopropylphenol, butylphenol, and p-tert-butylphenol; polyhydric phenols such as resorcinol, catechol, hydroquinone, pyrogallol, and floroglucinol; and biphenyl-based phenols such as 4,4'-biphenol. As the phenol compound, one kind or two or more kinds of phenol compounds among the specific examples can be used.

The aldehyde compound used in the above-described reactant of the phenol compound and the aldehyde compound is not limited as long as it is a compound having an aldehyde group.

Specific examples of such an aldehyde compound include formaldehyde, paraformaldehyde, acetaldehyde, benzaldehyde, and salicylaldehyde. As the aldehyde compound, one kind or two or more kinds of aldehyde compounds among the specific examples can be used.

The dimethanol compound used in the above-described reactant of the phenol compound and the dimethanol compound is not limited.

Specific examples of such a dimethanol compound include dimethanol compounds such as 1,4-benzenedimethanol, 1,3-benzenedimethanol, 4,4'-biphenyldimethanol, 3,4'-biphenyldimethanol, 3,3'-biphenyldimethanol, 2,6-naphthalenedimethanol, and 2,6-bis(hydroxymethyl)-p-cresol; bis(alkoxymethyl) compounds such as 1,4-bis(methoxymethyl)benzene, 1,3-bis(methoxymethyl)benzene, 4,4'-bis(methoxymethyl)biphenyl, 3,4'-bis(methoxymethyl)biphenyl, 3,3'-bis(methoxymethyl)biphenyl, and methyl 2,6-naphthalenedicarboxylate; bis(halogenoalkyl) compounds such as 1,4-bis(chloromethyl)benzene, 1,3-bis(chloromethyl)benzene, 1,4-bis(bromomethyl)benzene, 1,3-bis(bromomethyl)benzene, 4,4'-bis(chloromethyl)biphenyl, 3,4'-bis(chloromethyl)biphenyl, 3,3'-bis(chloromethyl)biphenyl, 4,4'-bis(bromomethyl)biphenyl, 3,4'-bis(bromomethyl)biphenyl, and 3,3'-bis(bromomethyl)biphenyl; and biphenyl aralkyl compounds such as 4,4'-bis(methoxymethyl)biphenyl and 4,4'-bis(methoxymethyl)biphenyl. As the dimethanol compound, one kind or two or more kinds of dimethanol compounds among the specific examples can be used.

### (Hydroxystyrene Resin)

The hydroxystyrene resin is not limited, and specifically, a polymerization reaction product or copolymerization reaction product obtained by polymerizing or copolymerizing one, or two or more selected from the group consisting of hydroxystyrene, a hydroxystyrene derivative, styrene, and a styrene derivative can be used.

Furthermore, specific examples of the hydroxystyrene derivative and the styrene derivative include hydroxystyrene and a compound in which a hydrogen atom in an aromatic ring of styrene is substituted with a monovalent organic group. Examples of the monovalent organic group substituting a hydrogen atom include alkyl groups such as a methyl group, an ethyl group, and an n-propyl group; alkenyl groups such as an allyl group and a vinyl group; alkynyl groups such as an ethynyl group; alkylidene groups such as a methylidene group and an ethylidene group; cycloalkyl groups such as a cyclopropyl group; and heterocyclic groups such as an epoxy group and an oxetanyl group.

### (Cyclic Olefin Resin)

The cyclic olefin resin is not limited, and specifically, a polymerization reaction product or copolymerization reaction product obtained by polymerizing or copolymerizing one, or two or more selected from the group consisting of norbornene and a norbornene derivative can be used.

Here, specific examples of the norbornene derivative include norbornadiene, bicyclo[2.2.1]-hept-2-ene (common name: 2-norbornene), 5-methyl-2-norbornene, 5-ethyl-2-norbornene, 5-butyl-2-norbornene, 5-hexyl-2-norbornene, 5-decyl-2-norbornene, 5-allyl-2-norbornene, 5-(2-propenyl)-2-norbornene, 5-(1-methyl-4-pentenyl)-2-norbornene, 5-ethynyl-2-norbornene, 5-benzyl-2-norbornene, 5-phenethyl-2-norbornene, 2-acetyl-5-norbornene, methyl 5-norbornene-2-carboxylate, and 5-norbornene-2,3-dicarboxylic anhydride.

The lower limit value of the content of the alkali-soluble resin (A) in the photosensitive resin composition is preferably 30 parts by mass or more, more preferably 40 parts by mass or more, still more preferably 50 parts by mass or more, even still more preferably 60 parts by mass or more, and further still more preferably 70 parts by mass or more in a case where a total solid content of the photosensitive resin composition is set to 100 parts by mass. This makes it possible to further improve the dispersibility of the alkali-soluble resin (A) in the photosensitive resin composition, and to further improve the anti-foaming properties of the photosensitive resin composition.

In addition, the upper limit value of the content of the alkali-soluble resin (A) in the photosensitive resin composition is preferably 95 parts by mass or less, more preferably 90 parts by mass or less, and still more preferably 85 parts by mass or less in a case where the total solid content of the photosensitive resin composition is set to 100 parts by mass.

Furthermore, the total solid content of the photosensitive resin composition indicates a total content of the components of the photosensitive resin composition excluding the solvent.

From the viewpoint of further improving the dispersibility of the alkali-soluble resin (A) in the photosensitive resin composition, a weight-average molecular weight (Mw) of the alkali-soluble resin (A) is preferably 5,000 or more, more preferably 6,000 or more, and still more preferably 7,000 or more, and is preferably 70,000 or less, more preferably 65,000 or less, and still more preferably 60,000 or less.

In addition, from the viewpoint of further improving the dispersibility of the alkali-soluble resin (A) in the photosensitive resin composition, the weight-average molecular weight (Mw) of the alkali-soluble resin (A) is preferably 5,000 or more and 70,000 or less, more preferably 6,000 or more and 65,000 or less, and still more preferably 7,000 or more and 60,000 or less.

### (Polyether-Modified Polydimethylsiloxane (B))

The polyether-modified polydimethylsiloxane (B) of the present embodiment preferably includes a polyether-modified polydimethylsiloxane represented by General Formula (1). This makes it possible to further improve the anti-foaming properties in a case of producing the photosensitive resin composition.

In addition, in the polyether-modified polydimethylsiloxane (B) represented by General Formula (1), the polydimethylsiloxane chain which is the main chain has a helical structure, and the dimethyl group or the polyether-modified group which is a side chain is disposed on a surface side of the helical structure. Therefore, there is an advantage that the characteristics of the polyether-modified polydimethylsiloxane (B) can be further controlled by the structure of the side chain.

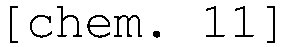

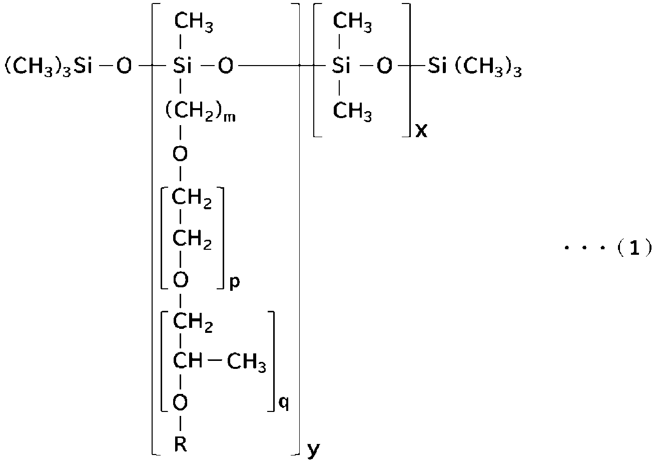

In General Formula (1), m preferably has an average value of 1 or more and 5 or less, p preferably has an average value of 1 or more and 10 or less, and q preferably has an average value of 0 or more and less than 1. R preferably represents hydrogen or an alkyl group having 1 or more and 5 or less carbon atoms.

In the polyether-modified polydimethylsiloxane (B), in General Formula (1), x has an average value of preferably 1 or more, and more preferably 2 or more, and of preferably 50 or less, and more preferably 40 or less.

In addition, in the polyether-modified polydimethylsiloxane (B), x in General Formula (1) is preferably 1 or more and 50 or less, and more preferably 2 or more and 40 or less.

In General Formula (1), y has an average value of preferably 1 or more, and more preferably 2 or more, and of preferably 10 or less, more preferably 8 or less, and still more preferably 6 or less.

In addition, in General Formula (1), y is preferably 1 or more and 10 or less, more preferably 2 or more and 8 or less, and still more preferably 2 or more and 6 or less.

Furthermore, in General Formula (1), a ratio (x/y) of x to y is preferably 1 or more, and more preferably 1.2 or more, and is preferably 5 or less, and more preferably 4 or less.

In addition, in General Formula (1), a ratio (x/y) of x to y is preferably 1 or more and 5 or less, and more preferably 1.2 or more and 4 or less.

In a case where x representing a dimethyl group in General Formula (1) is within the range, a surface tension of the entire photosensitive resin composition can be appropriately lowered. In addition, in a case where x/y is within the range, the compatibility among the polyether-modified polydimethylsiloxane (B), the alkali-soluble resin (A), and the solvent (C) and the photosensitizer (D) is more favorable.

Furthermore, as the polyether-modified group is more polar (hydrophilic), the foams are stabilized and the anti-foaming properties are lowered. In contrast, as the polyether-modified group is more low-polar (hydrophobic), the stability of foams is lowered and the anti-foaming properties are improved. In a case where m, p, and q in General Formula (1) are equal to or more than the lower limit values, the side chain of the polyether-modified polydimethylsiloxane (B) becomes appropriately non-polar (hydrophobic), the foam stability is lowered and the anti-foaming properties are more favorable. In addition, in a case where m, p, and q in General Formula (1) are each equal to or less than the upper limit value, the compatibility between the polyether-modified polydimethylsiloxane (B) and the solvent (C), in particular, γ-butyrolactone described later, is improved, and the anti-foaming properties are further improved.

In the polyether-modified polydimethylsiloxane (B), in General Formula (1), m has an average value of preferably 1 or more, and more preferably 2 or more, and of preferably 5 or less, and more preferably 4 or less.

In addition, in the polyether-modified polydimethylsiloxane (B), m in General Formula (1) is preferably 1 or more and 5 or less, and more preferably 2 or more and 4 or less.

p has an average value of preferably 1 or more, more preferably 3 or more, still more preferably 4 or more, and even more preferably 5 or more, and is preferably 10 or less, and more preferably 9 or less.

In addition, p has an average value of preferably 1 or more and 10 or less, more preferably 3 or more and 10 or less, still more preferably 4 or more and 9 or less, and even still more preferably 5 or more and 9 or less.

q has an average value of preferably 0 or more and less than 1. R preferably represents hydrogen or an alkyl group having 1 or more and 5 or less carbon atoms, more preferably represents hydrogen or a methyl group, and still more preferably represents hydrogen.

In a case where m, p, and q are within the ranges, the entire polyether-modified polydimethylsiloxane (B) is moderately non-polar (hydrophobic) and the anti-foaming properties of the photosensitive resin composition can be further improved. In addition, at the same time, the polyether-modified polydimethylsiloxane (B) can be dissolved in an aqueous solvent by being appropriately highly polar (hydrophilic).

The polyether-modified polydimethylsiloxane (B) can be synthesized from a polyether compound and polydimethylsiloxane. m, p, q, x, and y in General Formula (1) can be adjusted by adjusting the types and mixing the ratios of the polyether compound and the polydimethylsiloxane to be used.

m, p, q, x, and y in General Formula (1) can be determined from the structures of the polyether compound and the polydimethylsiloxane, which are used for synthesizing the polyether-modified polydimethylsiloxane (B). In addition, m, p, q, x, and y in General Formula (1) can also be specified by a known polymer structure analysis method such as NMR, IR, thermal decomposition GC-MS, TOF-SIMS, and LC-TOF/MS.

From the viewpoint of further improving the anti-foaming properties of the photosensitive resin composition, a ratio (Mw/Mn) of the weight-average molecular weight (Mw) to the number-average molecular weight (Mn) of the polyether-modified polydimethylsiloxane (B) is preferably 1 or more, and more preferably 2 or more, and is preferably 10 or less, more preferably 8 or less, still more preferably 7 or less, even still more preferably 6 or less, further still more preferably 4 or less, and further still more preferably 3 or less.

In addition, from the viewpoint of further improving the anti-foaming properties of the photosensitive resin composition, the ratio (Mw/Mn) of the weight-average molecular weight (Mw) to the number-average molecular weight (Mn) of the polyether-modified polydimethylsiloxane (B) is preferably 1 or more and 10 or less, more preferably 1 or more and 8 or less, still more preferably 1 or more and 7 or less, even still more preferably 2 or more and 6 or less, further still more preferably 2 or more and 4 or less, and further still more preferably 2 or more and 3 or less.

The weight-average molecular weight of a maximum peak of the polystyrene-equivalent molecular weight distribution of the polyether-modified polydimethylsiloxane (B), measured by gel permeation chromatography, is preferably 1,000 or more, more preferably 1,300 or more, and still more preferably 1,800 or more, and is preferably 5,000 or less, and more preferably 4,000 or less.

In addition, the weight-average molecular weight of the maximum peak of the polystyrene-equivalent molecular weight distribution of the polyether-modified polydimethylsiloxane (B), measured by gel permeation chromatography, is preferably 1,000 or more and 5,000 or less, more preferably 1,300 or more and 5,000 or less, and still more preferably 1,800 or more and 4,000 or less.

In a case where the weight-average molecular weight of the maximum peak of the polyether-modified polydimethylsiloxane (B) is within the range, the anti-foaming properties of the photosensitive resin composition are further improved. In addition, in a case where the weight-average molecular weight of the maximum peak of the polyether-modified polydimethylsiloxane (B) is equal to or less than the upper limit value, the compatibility with γ-butyrolactone described later is improved and the anti-foaming properties of the photosensitive resin composition are further improved.

The number-average molecular weight (Mn) and the weight-average molecular weight of the maximum peak of the polyether-modified polydimethylsiloxane (B) are the same as the above-described weight-average molecular weight (Mw) of the polyether-modified polydimethylsiloxane (B), and are polystyrene-equivalent values measured by gel permeation chromatography (GPC).

The weight-average molecular weight of the maximum peak of the polyether-modified polydimethylsiloxane (B) can be calculated by peak separation of chromatography obtained by gel permeation chromatography (GPC). As the peak separation software, for example, Eco-SEC manufactured by Tosoh Corporation can be used. Furthermore, the maximum peak represents a peak at which the integrated value of the peak is maximum.

From the viewpoint of making the anti-foaming properties of the photosensitive resin composition more favorable, the surface tension (mN/m) of the polyether-modified polydimethylsiloxane (B) is preferably 20 mN/m or more, more preferably 25 mN/m or more, and still more preferably 27 mN/m or more, and is preferably 40 mN/m or less, more preferably 35 mN/m or less, and still more preferably 30 mN/m or less.

The surface tension (mN/m) of the polyether-modified polydimethylsiloxane (B) is measured using a contact angle meter under a condition of 23°C as a 1% GBL solution. As the contact angle meter, DMs-401 (Kyowa Interface Science Co., Ltd.) can be used.

From the viewpoint of including as few low-molecular-weight components as possible, a density (g/mL) of the polyether-modified polydimethylsiloxane (B) measured at 20°C in accordance with ISO 2811-3: 2011 is preferably 0.90 g/mL or more, and more preferably 0.95 g/mL or more, and is preferably 1.15 g/mL or less, and more preferably 1.10 g/mL or less.

From the viewpoint of including as few low-molecular-weight components as possible, a refractive index of the polyether-modified polydimethylsiloxane (B) measured in accordance with DIN 51423 is preferably 1.30 or more, and more preferably 1.40 or more, and is preferably 1.60 or less, and more preferably 1.50 or less.

From the viewpoint of including as few low-molecular-weight components as possible, a non-volatile content of the polyether-modified polydimethylsiloxane (B) measured in accordance with ISO 3251:2019 under a heating condition of 105°C for 1 hour is preferably 85.0% or more, more preferably 87.0% or more, and still more preferably 90.0% or more.

A content of the polyether-modified polydimethylsiloxane (B) is preferably 10 ppm or more, more preferably 50 ppm or more, and still more preferably 90 ppm or more, and is preferably 3,000 ppm or less, more preferably 2,500 ppm or less, still more preferably 2,000 ppm or less, and even still more preferably 1,600 ppm or less, with respect to the entirety of photosensitive resin composition.

In addition, the content of the polyether-modified polydimethylsiloxane (B) is preferably 10 ppm or more and 3,000 ppm or less, more preferably 10 ppm or more and 2,500 ppm or less, still more preferably 50 ppm or more and 2,000 ppm or less, and even still more preferably 90 ppm or more and 1,600 ppm or less, with respect to the entirety of photosensitive resin composition.

In a case where the content of the polyether-modified polydimethylsiloxane (B) is within the range, the anti-foaming properties of the photosensitive resin composition can be further improved.

### (Solvent (C))

The solvent (C) according to the present embodiment preferably includes the following solvent (C1).

The solvent (C1) preferably includes at least one selected from the group consisting of γ-butyrolactone (GBL), N-methyl-2-pyrrolidone (NMP), N-ethyl-2-pyrrolidone (NEP), propylene glycol monomethyl ether (PGME), 3-methyl-2-oxazolidinone, 3-methoxy-N,N-dimethylpropanamide, and propylene glycol monomethyl ether acetate (PGMEA). From the viewpoint of further improving the anti-foaming properties of the photosensitive resin composition, the solvent preferably includes one selected from the group consisting of γ-butyrolactone (GBL), N-methyl-2-pyrrolidone (NMP), N-ethyl-2-pyrrolidone (NEP), and 3-methyl-2-oxazolidinone, and more preferably includes γ-butyrolactone.

The γ-butyrolactone has good compatibility with the above-described polyether-modified polydimethylsiloxane (B) from the viewpoint of making a surface tension of the entire photosensitive resin composition more appropriate and making a polarity of the polyether-modified polydimethylsiloxane (B) in the photosensitive resin composition more appropriate. Thus, the anti-foaming properties of the photosensitive resin composition can be further improved.

The solvent (C) may include other solvents other than the solvent (C1). Examples of such other solvents include urea-based solvents such as N,N-dimethylacetamide, tetramethylurea (TMU), 1,3-dimethyl-2-imidazolidinone, tetrabutylurea, N,N'-dimethylpropyleneurea, 1,3-dimethoxy-1,3-dimethylurea, N,N'-diisopropyl-O-methylisourea, O,N,N'-triisopropylisourea, O-tert-butyl-N,N'-diisopropylisourea, O-ethyl-N,N'-diisopropylisourea, and O-benzyl-N,N'-diisopropylisourea; alcohol-based solvents such as tetrahydrofurfuryl alcohol, benzyl alcohol, 2-ethylhexanol, butanediol, and isopropyl alcohol; ketone-based solvents such as cyclopentanone, cyclohexanone, diacetone alcohol, and 2-heptanone; carbonate-based solvents such as ethylene carbonate and propylene carbonate; sulfone-based solvents such as dimethyl sulfoxide (DMSO) and sulfolane; ester-based solvents such as methyl pyruvate, ethyl pyruvate, and methyl-3-methoxypropionate; and aromatic hydrocarbon-based solvents such as mesitylene, toluene, and xylene. As the solvent, one kind or a combination of two or more kinds of solvents among the specific examples can be used.

From the viewpoint of further improving the anti-foaming properties of the photosensitive resin composition, the content of the solvent (C1) is preferably 50% by mass or more, more preferably 60% by mass or more, still more preferably 70% by mass or more, even still more preferably 80% by mass or more, and further still more preferably 90% by mass or more, and is preferably 100% by mass or less, with respect to the entirety of solvent (C).

In addition, from the viewpoint of further improving the anti-foaming properties of the photosensitive resin composition, the content of the solvent (C1) is preferably 50% by mass or more and 100% by mass or less, more preferably 60% by mass or more and 100% by mass or less, still more preferably 70% by mass or more and 100% by mass or less, even still more preferably 80% by mass or more and 100% by mass or less, and further still more preferably 90% by mass or more and 100% by mass or less, with respect to the entirety of solvent (C).

From the viewpoint of further improving the coating properties of the photosensitive resin composition, the content of the solvent (C) is preferably 40% by mass or more, and more preferably 50% by mass or more, and is preferably 90% by mass or less, more preferably 85% by mass or less, and still more preferably 80% by mass or less in a case where the total content of the photosensitive resin composition is 100% by mass.

### (Photosensitizer (D))

As the photosensitizer (D), a photoacid generator that generates an acid by absorbing light energy can be used.

Specific examples of the photoacid generator include a diazoquinone compound; a diaryliodonium salt; a 2-nitrobenzyl ester compound; an N-iminosulfonate compound; an imidosulfonate compound; a 2,6-bis(trichloromethyl)-1,3,5-triazine compound; and a dihydropyridine compound. Among these, the photosensitive diazoquinone compound is preferably included in the photosensitizer (D). This makes it possible to further improve the sensitivity of the photosensitive resin composition. Therefore, the accuracy of the pattern can be improved and the appearance can be further improved. As the photoacid generator, one kind or two or more kinds of photoacid generators among the specific examples can be included.

In addition, in a case where the photosensitive resin composition is a positive type, in addition to the specific examples, an onium salt such as a triarylsulfonium salt and a sulfonium-borate salt may be used together as the photosensitizer (D). This makes it possible to further improve the sensitivity of the photosensitive resin composition.

Hereinafter, the diazoquinone compound will be exemplified using chemical formulae.

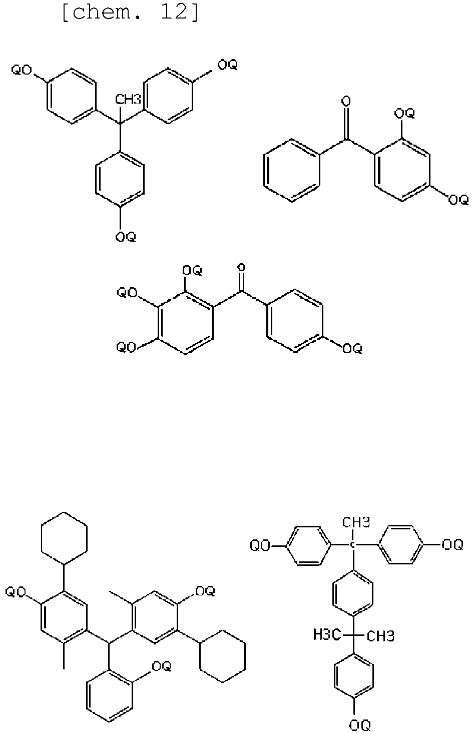

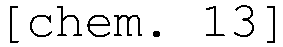

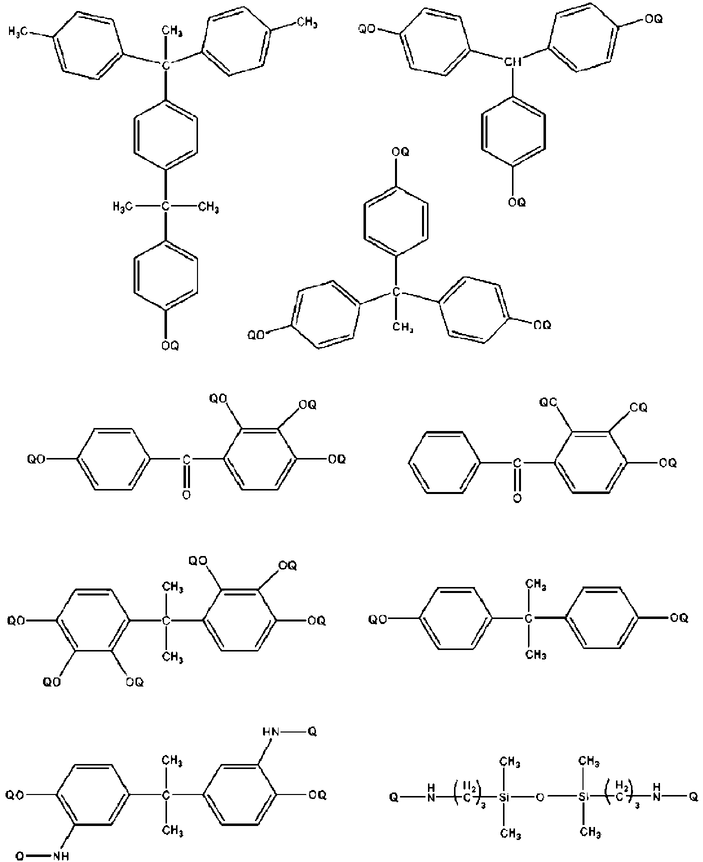

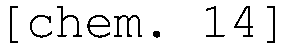

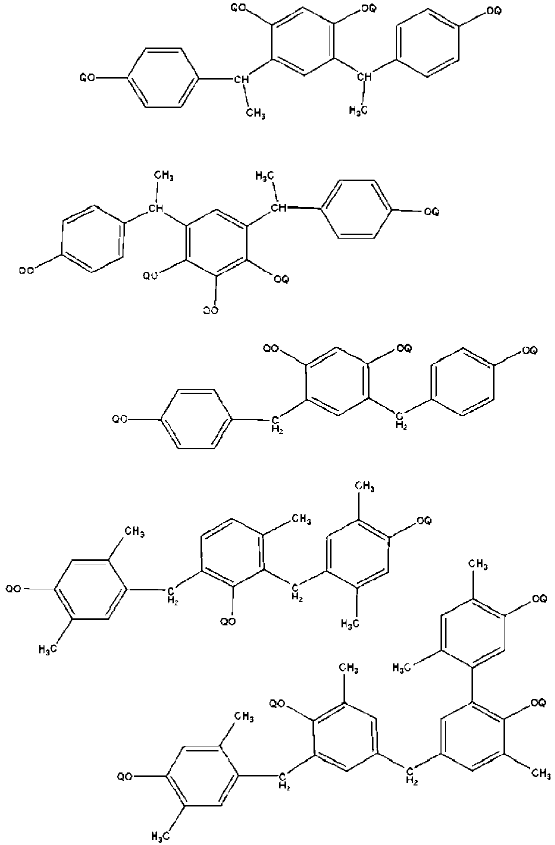

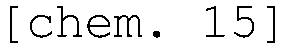

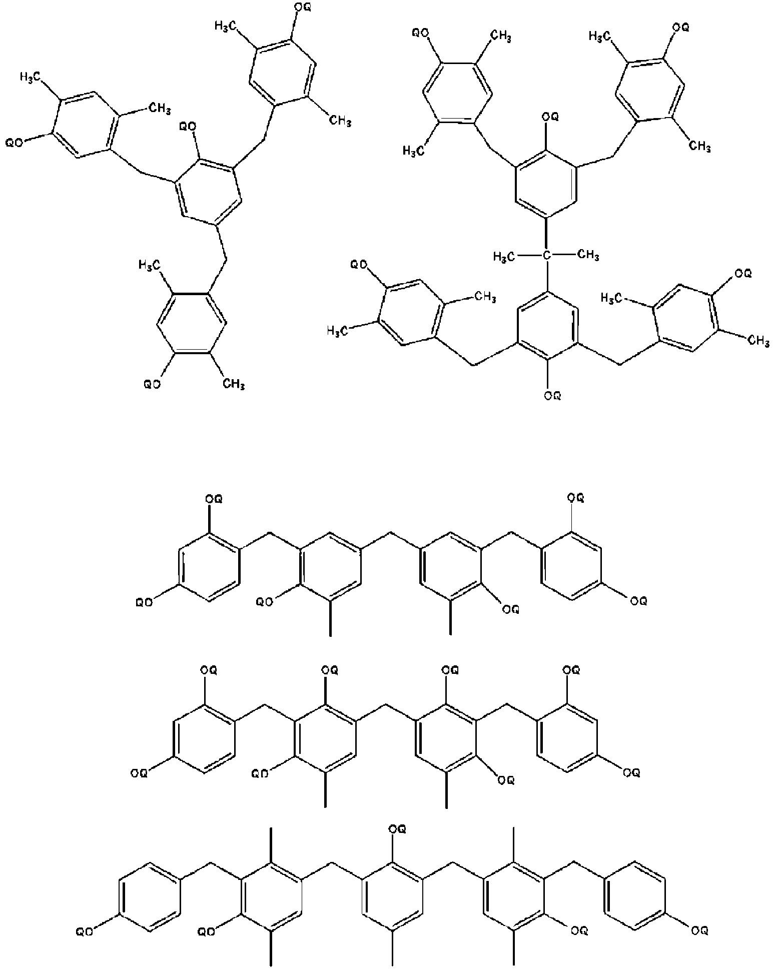

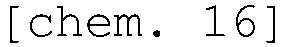

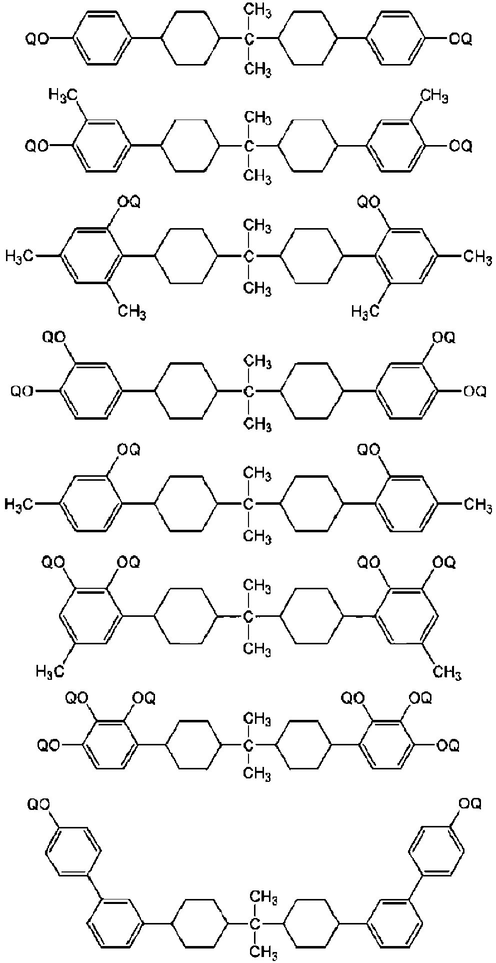

In each of the above diazoquinone compounds, Q represents a structure represented by Formula (a), Formula (b), or Formula (c), or a hydrogen atom. It should be noted that at least one of Q's in each of the diazoquinone compounds is the structure represented by Formula (a), Formula (b), or Formula (c).

It is preferable that Q of the diazoquinone compound includes Formula (a) or Formula (b). This makes it possible to further improve the transparency of the photosensitive resin composition. Therefore, the appearance of the photosensitive resin composition can be further improved.

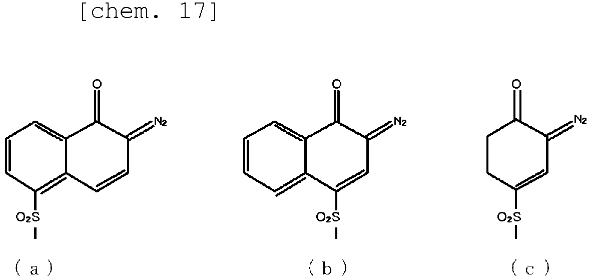

The lower limit value of the content of the photosensitizer (D) in the photosensitive resin composition is preferably 1 part by mass or more, more preferably 3 parts by mass or more, still more preferably 5 parts by mass or more, and even still more preferably 10 parts by mass or more in a case where the content of the alkali-soluble resin (A) is 100 parts by mass. This makes it possible for the photosensitive resin composition to exhibit appropriate sensitivity.

In addition, the upper limit value of the content of the photosensitizer (D) in the photosensitive resin composition is preferably 30 parts by mass or less, and more preferably 25 parts by mass or less in a case where the alkali-soluble resin (A) is set to 100 parts by mass. As a result, it is possible to suppress the photosensitive resin composition from being repelled by a metal material present on a surface of a substrate of a semiconductor device.

### (Adhesion Aid (E))

The photosensitive resin composition according to the present embodiment may further include an adhesion aid (E).

The adhesion aid (E) preferably includes one selected from the group consisting of a triazole compound, an aminosilane, an imide compound, an epoxysilane, a (meth)acrylic silane, and a reaction product of an epoxy compound and an aminotriazole. This makes it possible to further improve the affinity between the photosensitive resin composition and the metal member.

Specific examples of the triazole compound include 1,2,4-triazoles such as 4-amino-1,2,4-triazole, 4H-1,2,4-triazole-3-amine, 4-amino-3,5-di-2-pyridyl-4H-1,2,4-triazole, 3-amino-5-methyl-4H-1,2,4-triazole, 4-methyl-4H-1,2,4-triazole-3-amine, 3,4-diamino-4H-1,2,4-triazole, 3,5-diamino-4H-1,2,4-triazole, 1,2,4-triazole-3,4,5-triamine, 3-pyridyl-4H-1,2,4-triazole, 4H-1,2,4-triazole-3-carboxamide, 3,5-diamino-4-methyl-1,2,4-triazole, 3-pyridyl-4-methyl-1,2,4-triazole, and 4-methyl-1,2,4-triazole-3-carboxamide. As the triazole compound, one kind or a combination of two or more kinds of triazole compounds among the specific examples can be used.

Specific examples of the aminosilane include a condensate of cyclohexene-1,2-dicarboxylic anhydride and 3-aminopropyltriethoxysilane, a condensate of a 3,3',4,4'-benzophenone tetracarboxylic acid dianhydride and 3-aminopropyltriethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, N,N' bis[3-(trimethoxysilyl)propyl]ethylenediamine, N,N'-bis-(3-triethoxysilylpropyl)ethylenediamine, N, N'-bis[3-(methyldimethoxysilyl)propyl]ethylenediamine, N,N'-bis[3-(methyldiethoxysilyl)propyl]ethylenediamine, N,N'-bis[3-(dimethylmethoxysilyl)propyl]ethylenediamine, N-[3-(methyldimethoxysilyl)propyl]-N'-[3-(trimethoxysilyl)propyl]ethylenediamine, N,N'-bis[3-(trimethoxysilyl)propyl]diaminopropane, N,N'-bis[3-(trimethoxysilyl)propyl]diaminohexane, and N,N'-bis[3-(trimethoxysilyl)propyl]diethylenetriamine. As the aminosilane, one kind or a combination of two or more kinds of aminosilanes among the specific examples can be used.

Examples of the imide compound include compounds exemplified below. These can be used alone or in combination of two or more kinds thereof.

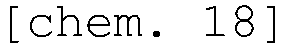

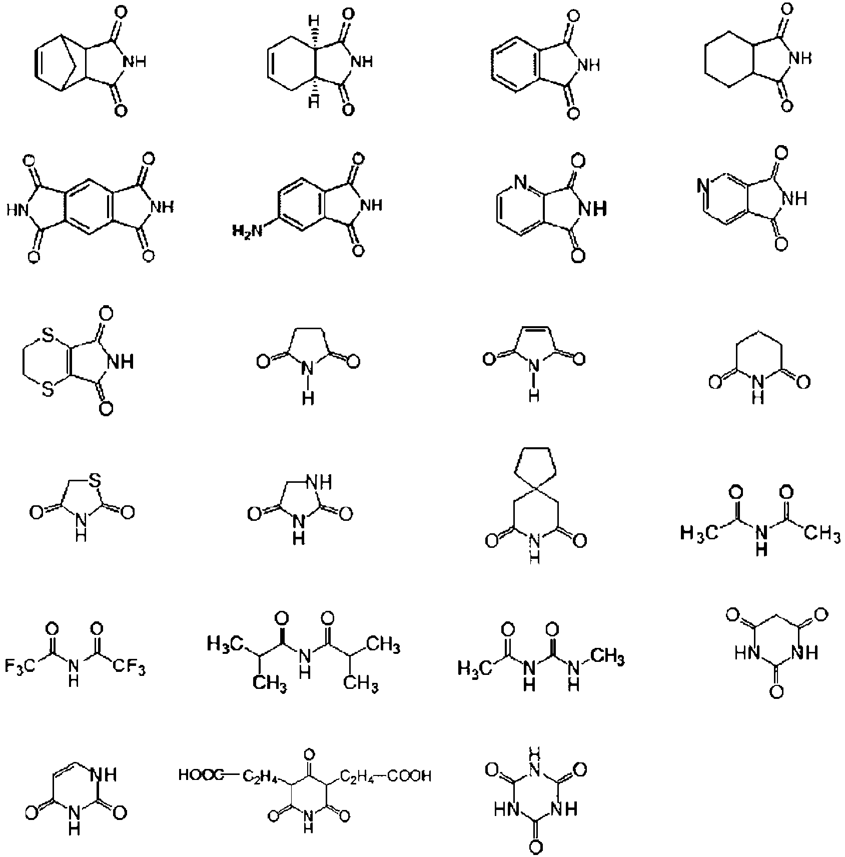

Specific examples of the epoxy silane include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane. As the epoxysilane, one kind or a combination of two or more kinds of epoxysilanes among the specific examples can be used.

Specific examples of the (meth)acrylic silane include 3-(meth)acryloxypropylmethyldimethoxysilane, 3-(meth)acryloxypropyltrimethoxysilane, 3-(meth)acryloxypropylmethyldiethoxysilane, and 3-(meth)acryloxypropyltriethoxysilane. As the (meth)acrylic silane, one kind or a combination of two or more kinds of (meth)acrylic silanes among the specific examples can be used.

Examples of the epoxy compound and the aminotriazole used in the reactant of the epoxy compound and the aminotriazole include the following ones.

The epoxy compound is not limited as long as it contains an epoxy group, and examples thereof include epoxy group-containing compounds such as a bisphenol A type epoxy resin, a bisphenol F type epoxy resin, a naphthalene-based epoxy resin, a biphenyl type epoxy resin, and a phenol novolac resin type epoxy resin. Examples of the aminotriazole include 3-amino-1,2,4-triazole and 4-amino-1,2,4-triazole.

The content of the adhesion aid (E) in the photosensitive resin composition is preferably 0 parts by mass or more, more preferably 1.0 parts by mass or more, still more preferably 2.0 parts by mass or more, and even still more preferably 3.0 parts by mass or more, and is preferably 15 parts by mass or less, more preferably 13 parts by mass or less, and even still more preferably 12 parts by mass or less, with respect to 100 parts by mass of the alkali-soluble resin (A).

In a case where the content of the adhesion aid (E) is within the range, the dispersibility of the adhesion aid (E) in the photosensitive resin composition is more favorable and the adhesion force of the photosensitive resin composition to the adherend can be further improved. This makes it possible to further suppress the foreign matter from being mixed between the resin film and the adherend of the resin film.

In the photosensitive resin composition according to the present embodiment, from the viewpoint of further improving the anti-foaming properties of the photosensitive resin composition and further improving the coating properties of the photosensitive resin composition, the total content of the alkali-soluble resin (A), the polyether-modified polydimethylsiloxane (B), the solvent (C), and the photosensitizer (D) is preferably 60% by mass or more, more preferably 70% by mass or more, still more preferably 80% by mass or more, and even still more preferably 90% by mass or more, and may be, for example, 100% by mass or less or 99% by mass or less in a case where the total content of the photosensitive resin composition is 100% by mass.

In the photosensitive resin composition according to the present embodiment, from the viewpoint of further improving the anti-foaming properties of the photosensitive resin composition and further improving a balance of the performance of the mechanical properties and the performance of the coating properties of the photosensitive resin composition, the total content of the alkali-soluble resin (A) and the polyether-modified polydimethylsiloxane (B) is preferably 10% by mass or more, more preferably 15% by mass or more, and still more preferably 20% by mass or more, and is preferably 50% by mass or less, more preferably 45% by mass or less, and still more preferably 40% by mass or less in a case where the total content of the photosensitive resin composition is 100% by mass.

The photosensitive resin composition according to the present embodiment may further include additives such as a thermal crosslinking agent, an antioxidant, a dissolution accelerator, a filler, and a sensitizer.

### (Thermal Crosslinking Agent)

The photosensitive resin composition according to the present embodiment may further include a thermal crosslinking agent. This makes it possible to further improve the mechanical properties and the like of a cured product of the photosensitive resin composition.

Examples of the thermal crosslinking agent include a compound having a methylol group; phenols; a compound having an alkoxymethyl group; a methylol melamine compound; an alkoxymelamine compound; an alkoxymethyl glycoluril compound; a methylol urea compound; a cyano compound; an isocyanate compound; an epoxy group-containing compound; a maleimide compound; and a xylene derivative. As the thermal crosslinking agent, one kind or a combination of two or more kinds of thermal crosslinking agents among the specific examples can be used.

### (Antioxidant)

The photosensitive resin composition according to the present embodiment may further include an antioxidant. As the antioxidant, at least one or more selected from a phenol-based antioxidant, a phosphorus-based antioxidant, and a thioether-based antioxidant can be used. The antioxidant can further suppress the oxidation of a resin film formed from the photosensitive resin composition.

### (Dissolution Accelerator)

The photosensitive resin composition according to the present embodiment may further include a dissolution accelerator. The dissolution accelerator is a component which is capable of improving the solubility of an exposed portion of a coating film formed of the photosensitive resin composition in a developer to reduce scum during patterning. As such a dissolution accelerator, a compound having a phenolic hydroxyl group is preferable.

In a case where the alkali-soluble resin (A) includes a polybenzoxazole resin having an aromatic ring or a polyimide resin having an aromatic ring, the dissolution accelerator preferably includes a compound having a skeleton of a bisphenol type or a skeleton of a bisphenol A type. This makes it possible for the skeleton of the alkali-soluble resin (A) and the dissolution accelerator to interact with each other, and thus to further improve the dispersibility of the alkali-soluble resin (A).

### (Filler)

The photosensitive resin composition according to the present embodiment may further include a filler. As the filler, an appropriate filling material can be selected according to the mechanical properties and the thermal properties required for a resin film formed of the photosensitive resin composition, and specific examples thereof include an inorganic filler and an organic filler.

Examples of the inorganic filler include silica; a metal compound; talc; clay; mica; and glass fibers. Specific examples of the organic fillers include organosilicone powder and polyethylene powder.

As the fillers, one kind or a combination of two or more kinds of fillers among those can be used.

### (Preparation of Photosensitive Resin Composition)

A method for preparing the photosensitive resin composition in the present embodiment is not limited, and a known method can be used according to the components included in the photosensitive resin composition.

For example, the photosensitive composition can be prepared by mixing and dissolving the alkali-soluble resin (A), the polyether-modified polydimethylsiloxane (B), and the photosensitizer (D) in the solvent (C). This makes it possible for a photosensitive resin composition as a varnish to be obtained.

### (Cured Film)

The photosensitive resin composition of the present embodiment is used for forming a cured film of a semiconductor device such as a wafer level package and a panel level package.

The cured film is composed of, for example, a cured film obtained by applying a photosensitive resin composition, performing pre-baking, exposure, and development, patterning the photosensitive resin composition into a desired shape, and then curing the photosensitive resin composition by post-baking. The cured film can be used for a buffer coating film (protective film), an interlayer film, a dam material, or the like of an electronic device. The cured film can be suitably used as the buffer coating film among those.

Furthermore, in the step of producing a cured film, a step of applying the photosensitive resin composition is preferably performed by, for example, spin coating. This makes it possible for a more uniform resin film to be formed over the substrate.

The thickness of the cured film is not particularly limited, but is, for example, 2 µm or more and 30 µm or less, and preferably 5 µm or more and 20 µm or less.

After the photosensitive resin composition is applied, various methods can be applied to a method for removing the solvent (for example, heating), but in a case of being used for a panel level package, it is preferable to apply drying under reduced pressure in consideration of a relatively large area. That is, it is preferable that a panel coated with the photosensitive resin composition is dried in a reduced-pressure environment (for example, an environment of 30 Pa or less).

In a case of performing the pre-baking, the conditions thereof are, for example, 70°C to 160°C for about 5 seconds to 30 minutes.

For the exposure, electromagnetic waves, particle beams having various wavelengths, or the like can be used. For example, ultraviolet rays such as g-rays and i-rays, visible light, lasers, X-rays, electron beams, of the like are used. The ultraviolet rays such as g-rays and i-rays are preferable. The exposure amount is appropriately set depending on the sensitivity of the photosensitive resin composition, and the like, and is, for example, about 30 to 3,000 mJ/cm². The exposure is usually performed using an appropriate mask pattern.

For the development, various developers can be applied. Examples of the developer include alkali developers such as an alkali metal carbonate, an alkali metal hydroxide, and tetramethylammonium hydroxide, and organic developers such as dimethylformamide, N-methyl-2-pyrrolidone, propylene glycol monomethyl ether acetate, propylene glycol monomethyl ether, and butyl acetate. Among these, the alkali developers are preferable, and in particular, an aqueous solution of tetramethylammonium hydroxide is preferable. Examples of a method for supplying the developer include methods such as spraying, puddling, and immersion. For a treatment of a panel having a large area, the spraying method is preferable.

The post-baking conditions (curing conditions) are not particularly limited, but are, for example, a temperature of 80°C or higher and 450°C or lower, and 30 minutes or longer and 300 minutes or shorter.

### (Electronic Device)

Next, an example of an electronic device 100 including the photosensitive resin composition of the present embodiment will be described.

The electronic device 100 shown in Fig. 1 is, for example, a semiconductor chip. In this case, for example, by mounting the electronic device 100 over an interconnect substrate through a bump 52, a semiconductor package can be obtained. The electronic device 100 includes a semiconductor substrate provided with a semiconductor element such as a transistor, and a multilayered interconnect layer provided over the semiconductor substrate (not shown in the drawing). The uppermost layer of the multilayered interconnect layer is provided with an insulating interlayer 30 and an uppermost layer interconnect 34 provided over the insulating interlayer 30. The uppermost layer interconnect 34 is composed of, for example, Al. A passivation film 32 is provided over the insulating interlayer 30 and the uppermost layer interconnect 34. An opening through which the uppermost layer interconnect 34 is exposed is provided in a part of the passivation film 32.

A re-interconnect layer 40 is provided over the passivation film 32. The re-interconnect layer 40 has an insulating layer 42 provided over the passivation film 32, a re-interconnect 46 provided over the insulating layer 42, and an insulating layer 44 provided over the insulating layer 42 and the re-interconnect 46. An opening through which the uppermost layer interconnect 34 is exposed is formed in the insulating layer 42. The re-interconnect 46 is formed over the insulating layer 42 and in the opening provided in the insulating layer 42, and is electrically connected to the uppermost layer interconnect 34. The insulating layer 44 is provided with an opening through which a predetermined region of the re-interconnect 46 is exposed. A bump 52 is formed in the opening provided in the insulating layer 44, for example, through an Under Bump Metallurgy (UBM) layer 50. The electronic device 100 is connected to an interconnect substrate or the like, for example, through the bump 52.

In the present embodiment, one or more of the insulating layer 42 and the insulating layer 44 can be formed of, for example, a cured film formed by curing the above-described photosensitive resin composition. In this case, for example, the insulating layer 42 or the insulating layer 44 is formed by exposing a coating film formed of the photosensitive resin composition to ultraviolet rays, performing development, and then thermally curing the coating film.

### (Method for Manufacturing Electronic Device)

The method for manufacturing an electronic device of the present embodiment includes a coating film forming step of applying the photosensitive resin composition of the present embodiment onto a substrate to form a coating film.

In addition, the method for manufacturing an electronic device of the present embodiment may further include an exposure step of exposing the formed coating film, a development step of developing the exposed coating film, and a heating step of heating the coating film remaining after the development to cure the coating film, thereby forming a cured film. As a result, a cured film of the photosensitive resin composition is formed, and this cured film is used as the insulating layer 42 or the insulating layer 44 constituting the electronic device 100.

In addition, the method for manufacturing an electronic device of the present embodiment may further include a step of washing the coating film on the back side of the substrate after the coating film forming step. As a result, in a case of forming a coating film by spin coating or the like, an unnecessary coating film that has turned to the back side of the substrate can be removed, and the shape of the end part of the cured film formed from the coating film can be made more favorable.

Since the photosensitive resin composition of the present embodiment has an affinity within an appropriate range for a back-rinse solvent used for removing an unnecessary coating film during the formation of a coating film, the shape of the end part of the cured film can be made appropriate. Specifically, since the photosensitive resin composition of the present embodiment has a moderately low affinity for the back-rinse solvent, the back-rinse solvent can be prevented from being entrained to a surface of the substrate, that is, the coating film formed of the photosensitive resin composition over the substrate, and the coating film is not inadvertently dissolved, and in a case where the coating film is pre-baked and cured to form a cured film, the occurrence of unexpected step difference, defect, or the like at the end part can be suppressed and the end part shape can be made more favorable. In addition, since the photosensitive resin composition of the present embodiment has a moderately high affinity for the back-rinse solvent, it is possible to achieve the original purpose of the back-rinse solvent, that is, to remove the unnecessary photosensitive resin composition that has leaked to the back side of the substrate during the formation of the coating film.

In a case where the affinity between the photosensitive resin composition of the present embodiment and the back-rinse solvent is evaluated by the following method, the infiltration diameter of the back-rinse solvent is preferably 15 mm or more, more preferably 18 mm or more, and still more preferably 20 mm or more, and is preferably 28 mm or less, more preferably 26 mm or less, and still more preferably 23 mm or less.

In a case where the infiltration diameter is equal to or less than the upper limit value (the back-rinse solvent not being excessively infiltrated), the affinity between the photosensitive resin composition and the back-rinse solvent can be appropriately lowered and the shape of the end part of the coating film can be made more favorable.

By setting the infiltration diameter to be equal to or more than the lower limit value (the back-rinse solvent being appropriately infiltrated), the affinity between the photosensitive resin composition and the back-rinse solvent can be appropriately improved and an unnecessary coating film on the back surface of the substrate can be washed and removed as intended.

The affinity between the photosensitive resin composition and the back-rinse solvent is evaluated by the following method.

The photosensitive resin composition is spin-coated on a substrate so that the film thickness is 20 µm, thereby forming a coating film. 7 mg of the back-rinse solvent is added dropwise onto a surface of the coating film from a height of 5 cm from a surface of the coating film immediately after the formation using a dropper. The infiltration diameter (the diameter of a portion into which the back-rinse solvent has infiltrated) (mm) of the back-rinse solvent over the coating film immediately after the dropwise addition is measured.

As the back-rinse solvent, OK73 Thinner (PGME/PGMEA = 7/3) manufactured by Tokyo Ohka Kogyo Co., Ltd. can be used.

The embodiments of the present invention have been described above, but these are examples of the present invention and various configurations other than those can be adopted. Examples

Hereinafter, the present invention will be described with reference to Examples and Comparative Examples, but the present invention is not limited thereto.

### <Synthesis of Alkali-Soluble Resin 1>

An alkali-soluble resin 1 which is a polyamide resin was synthesized by the following procedure.

170.20 g (0.346 mol) of a mixture of dicarboxylic acid derivatives obtained by reacting 206.58 g (0.800 mol) of diphenyl ether-4,4'-dicarboxylic acid represented by Formula (DC2) with 216.19 g (1.600 mol) of 1-hydroxy-1,2,3-benzotriazole monohydrate, 4.01 g (0.047 mol) of 5-aminotetrazole, 45.22 g (0.196 mol) of 4,4'-methylenebis(2-aminophenol) represented by Formula (DA2), and 56.24 g (0.196 mol) of 4,4'-methylenebis(2-amino-3,6 dimethylphenol) represented by Formula (DA3) were placed in a four-necked glass separable flask equipped with a thermometer, a stirrer, a raw material inlet, and a drying nitrogen gas introduction pipe. Thereafter, 578.3 g of N-methyl-2-pyrrolidone was added to the separable flask to dissolve each of the raw material components. Next, the mixture was reacted at 90°C for 5 hours using an oil bath. Then, 24.34 g (0.141 mol) of 4-ethynylphthalic anhydride and 121.7 g of N-methyl-2-pyrrolidone were added to the separable flask, and the mixture was reacted at 90°C for 2 hours with stirring and then cooled to 23°C to terminate the reaction.

A filtrate obtained by filtering the reaction mixture in the separable flask was put into a solution of water/isopropanol = 7/4 (volume ratio). Thereafter, the precipitate was filtered, washed sufficiently with water and then dispersed in N-methylpyrrolidone (NMP) without drying to obtain a solution of a target alkali-soluble resin 1. The weight-average molecular weight Mw of the obtained alkali-soluble resin 1 was 18,081.

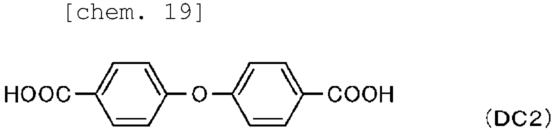

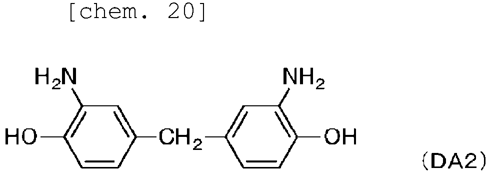

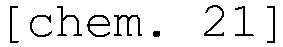

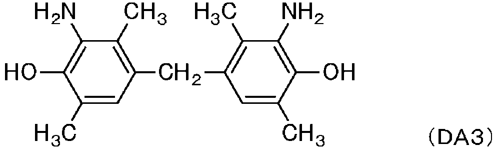

### <Synthesis of Photosensitizer 1>

A photosensitizer 1 which is a diazoquinone compound was synthesized by the following procedure.

11.04 g (0.026 mol) of a compound represented by Formula (P-1), 18.81 g (0.070 mol) of 1,2-naphthoquinone-2-diazide-5-sulfonyl chloride, and 170 g of acetone were placed in a four-necked separable flask equipped with a thermometer, a stirrer, a raw material inlet, and a drying nitrogen gas introduction pipe, and then stirred and dissolved.

Then, a mixed solution of 7.78 g (0.077 mol) of triethylamine and 5.5 g of acetone was slowly added dropwise thereto while cooling the flask with a water bath so that the temperature of the reaction solution did not reach 35°C or higher. After reacting the mixture at room temperature for 3 hours, 1.05 g (0.017 mol) of acetic acid was added thereto and further reacted for 30 minutes. Next, the reaction mixture was filtered and then the filtrate was added to a mixed solution of water/acetic acid (990 mL/10 mL). Then, the precipitate was collected by filtration, washed thoroughly with water, and dried under vacuum. As a result, a photosensitizer 1 represented by a structure of Formula (Q-1) was obtained.

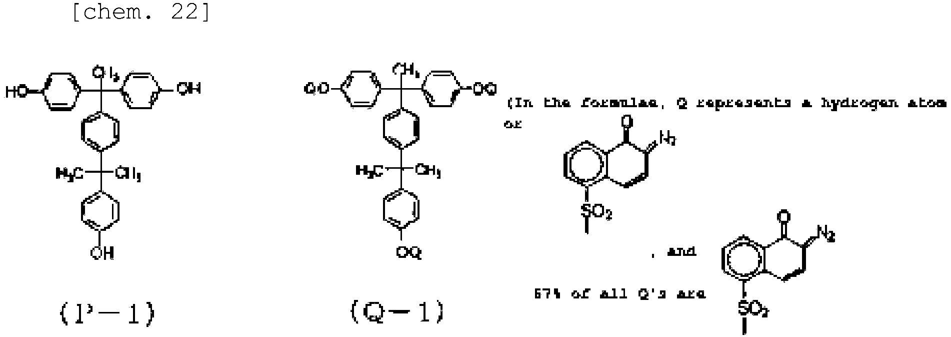

### <Thermal Crosslinking Agent>

· Thermal crosslinking agent 1: Paraxylene glycol (manufactured by Iharanikkei Chemical Industry Co., Ltd., PXG)

### <Dissolution Accelerators>

· Dissolution accelerator 1: 2,2'-Methylenebisphenol (manufactured by Honshu Chemical Industry Co., Ltd., product name: o,o'-BPF)
· Dissolution accelerator 2: Compound represented by Formula (2), manufactured by Air Water Inc.

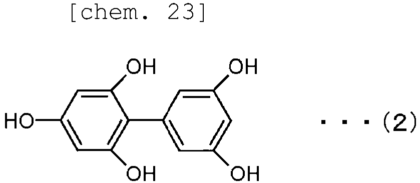

### <Adhesion Aids>

· Adhesion aid 1: 3-Methacryloxypropyltrimethoxysilane
· Adhesion aid 2: 3-Glycidoxypropyltriethoxysilane

### <Solvents>

Solvent 1: γ-Butyrolactone (GBL)
Solvent 2: N-Methyl-2-pyrrolidone (NMP)

### <Surfactant>

· Fluorine-based surfactant 1: FC4432, manufactured by 3M Japan Limited, weight-average molecular weight (Mw): 8,202, maximum peak molecular weight: 16,182, surface tension: 24.2 mN/m

### <Synthesis of Polyether-Modified Polydimethylsiloxane 1>

The polyether-modified polydimethylsiloxane 1 was synthesized using a polyether compound represented by Formula (3) instead of a polydimethylsiloxane represented by Formula (4) and the dimetallyl polyether, with reference to Synthesis Example 2 of paragraph 0115 of Japanese Unexamined Patent Publication No. 2002-079109.

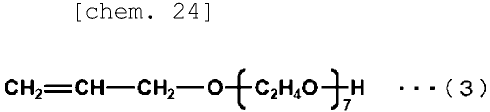

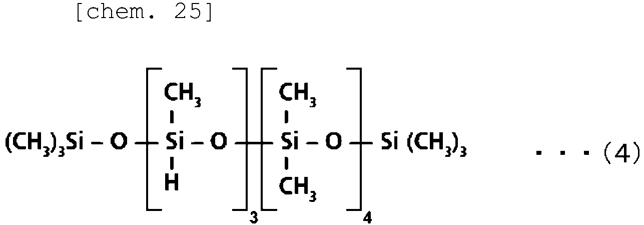

In the obtained polyether-modified polydimethylsiloxane 1, m was 3, p was 7, q was 0, x was 4, y was 3, and R was hydrogen in General Formula (1). Furthermore, m, p, q, x, and y in General Formula (1) were determined from the structures of the polydimethylsiloxane represented by Formula (4) and the polyether compound represented by Formula (3) used in the synthesis of the polyether-modified polydimethylsiloxane 1.

In a case where the polystyrene-equivalent weight-average molecular weight of the obtained polyether-modified polydimethylsiloxane 1 was measured by a gel permeation chromatography method described later, it was 1,730. Furthermore, the weight-average molecular weight of the maximum peak of the polystyrene-equivalent molecular weight distribution and the Mw/Mn were 2,234 and 2.23, respectively.

In addition, the polyether-modified polydimethylsiloxane 1 had a surface tension of 29.4 mN/m, a density of 1.037 ± 0.030 g/mL, a refractive index of 1.433 ± 0.010, and a non-volatile content of 96.25 ± 3.75%.

### <Synthesis of Polyether-Modified Polydimethylsiloxane 2>

The polyether-modified polydimethylsiloxane 2 was synthesized in accordance with the above-described synthesis of the polyether-modified polydimethylsiloxane 1, except that the types and the formulation ratios of the polydimethylsiloxane and the polyether compound were changed.

In the obtained polyether-modified polydimethylsiloxane 2, m was 3, p was 3, q was 5, x was 3, y was 3, and R was hydrogen in General Formula (1). m, p, q, x, and y in General Formula (1) were determined from the structures of the polydimethylsiloxane and the polyether compound used in the synthesis of the polyether-modified polydimethylsiloxane 2.

In addition, the obtained polyether-modified polydimethylsiloxane 2 had a polystyrene-equivalent weight-average molecular weight of 5,821, a weight-average molecular weight of a maximum peak of a polystyrene-equivalent molecular weight distribution of 7,367, and an Mw/Mn of 2.77, each measured by a gel permeation chromatography method described later.

### (Density, Refractive Index, and Non-Volatile Content)

The density of the polyether-modified polydimethylsiloxane was measured at 20°C in accordance with ISO 2811-3:2011.

The refractive index of the polyether-modified polydimethylsiloxane was measured in accordance with DIN 51423.

The non-volatile content of the polyether-modified polydimethylsiloxane was measured under conditions of 105°C and 1 hour in accordance with ISO 3251:2019.

### (Measurement of Molecular Weight of Alkali-Soluble Resin by Gel Permeation Chromatography Method)

The weight-average molecular weight (Mw) of the alkali-soluble resin was measured by the following method.
· Device: Gel permeation chromatography device manufactured by JASCO Corporation
·Pump: PU980 manufactured by JASCO Corporation
·Column oven: CO-965 manufactured by JASCO Corporation
·Sampler: AS-2055 manufactured by JASCO Corporation
·Column: Gelpack GL-83COMDT-5P manufactured by Hitachi High-Tech Corporation
· Detector: RI Detector for liquid chromatogram
· Measurement temperature: 40°C
· Solvent: THF
·Flow rate: 0.350 mL/min
·Sample concentration in measurement solution: 2.0 mg/mL

### (Measurement of Molecular Weight of Polyether-Modified Polydimethylsiloxane by Gel Permeation Chromatography Method)

For the polyether-modified polydimethylsiloxane and the fluorine-based surfactant, the weight-average molecular weight (Mw), the number-average molecular weight (Mn), and the weight-average molecular weight of the maximum peak of the polystyrene-equivalent molecular weight distribution were measured by the following method.
· Gel permeation chromatography device HLC-8320GPC manufactured by Tosoh Corporation
· Peak separation software: Eco-SEC, manufactured by Tosoh Corporation
· Column: TSK-GEL Supermultipore HZ-M manufactured by Tosoh Corporation
. Detector: RI Detector for liquid chromatogram
· Measurement temperature: 40°C
· Solvent: THF
· Flow rate: 0.35 mL/min
· Sample concentration in measurement solution: 2.0 mg/mL

### (Surface Tension)

For the polyether-modified polydimethylsiloxane and the fluorine-based surfactant, the surface tension (mN/m) was measured under a condition of 23°C as a 1% GBL solution using a contact angle meter (DMs-401, Kyowa Interface Science Co., Ltd.) .

### (Preparation of Photosensitive Resin Composition and Evaluation of Anti-Foaming Properties)

Photosensitive resin compositions of Examples and Comparative Examples were prepared as follows, and anti-foaming properties thereof were evaluated.

Each of the raw material components other than the polyether-modified polydimethylsiloxane and the fluorine-based surfactant was placed in a stirring container (bottom surface area: 70 cm²) according to the formulation in Table 1 such that the total amount of the photosensitive resin composition was 500 mL, and the mixture was stirred under the conditions of temperature: 23°C, height of stirring blade: 1.0 cm from the bottom, rotation speed: 250 rpm, and stirring time: 3 hours in a nitrogen atmosphere. After the completion of the stirring, the surfactant was added according to the formulation in Table 1, and the mixture was stirred under the conditions of temperature: 23°C, height of stirring blade: 1.0 cm from below, rotation speed: 100 rpm, and stirring time: 30 minutes in a nitrogen atmosphere to obtain a photosensitive resin composition of each example.

5 mL of the obtained photosensitive resin composition was placed in a 20 mL-capacity measuring cylinder immediately after the production, and allowed to stand for 15 hours under a condition of 23°C. After 15 hours, the foam height (mm) was measured. The results are shown in Table 1. Furthermore, the lower the foam height, the better the anti-foaming properties.

**[Table 1]**

| Photosensitive resin composition | | Unit | Example 1 | Example 2 | Example 3 | Example 4 | Example 5 | Example 6 | Example 7 | Example 8 | Example 9 | Example 10 | Example 11 | Comparative Example 1 | Comparative Example 2 | Comparative Example 3 |
|---|---|---|---|---|---|---|---|---|---|---|---|---|---|---|---|---|
| Composition | (A) Alkali-soluble resin 1 | Parts by mass | 100 | 100 | 100 | 100 | 100 | 100 | 100 | 100 | 100 | 100 | 100 | 100 | 100 | 100 |
| | (D) Photosensitizer | Parts by mass | 18 | 18 | 18 | 18 | 18 | 18 | 18 | 18 | 18 | 18 | 18 | 18 | 18 | 18 |
| | Dissolution accelerator 1 | Parts by mass | 6 | 6 | 6 | 6 | 6 | 6 | 6 | 0 | 6 | 6 | 0 | 6 | 6 | 6 |
| | Dissolution accelerator 2 | Parts by mass | 0 | 0 | 0 | 0 | 0 | 0 | 0 | 0 | 0 | 0 | 5 | 0 | 0 | 0 |
| | Thermal crosslinking agent 1 | Parts by mass | 0 | 0 | 0 | 0 | 0 | 0 | 0 | 5 | 0 | 2 | 5 | 0 | 0 | 0 |
| | (E) Adhesion aid 1 | Parts by mass | 8 | 8 | 8 | 8 | 0 | 0 | 0 | 0 | 0 | 0 | 0 | 8 | 8 | 8 |
| | (E) Adhesion aid 2 | Parts by mass | 0 | 0 | 0 | 0 | 5 | 5 | 5 | 5 | 0 | 5 | 5 | 0 | 0 | 0 |
| | (B) Polyether-modified oolvdimethylsiloxane 1 | ppm | 300 | 1,000 | 1,500 | 1,500 | 800 | 800 | 1,000 | 1,500 | 1,500 | 1,500 | 1,500 | 0 | 0 | 0 |
| | (B) Polyether-modified oolvdimethvlsiloxane 2 | | 0 | 0 | 0 | 0 | 0 | 300 | 300 | 0 | 0 | 0 | 0 | 300 | 1,500 | 0 |
| | Fluorine-based surfactant 1 | | 0 | 0 | 0 | 0 | 0 | 0 | 0 | 0 | 0 | 0 | 0 | 0 | 0 | 500 |
| | (C1) Solvent 1 | Parts by mass | 190 | 190 | 190 | 95 | 190 | 190 | 190 | 190 | 190 | 190 | 190 | 190 | 190 | 190 |
| | (C1) Solvent 2 | Parts by mass | 0 | 0 | 0 | 95 | 0 | 0 | 0 | 0 | 0 | 0 | 0 | 0 | 0 | 0 |
| Evaluation | Anti-foaming properties (foam height) | mm | 0 | 0 | 0 | 0 | 0 | 0 | 0 | 0 | 0 | 0 | 0 | 4 | 8 | 2 |

### <Evaluation of Affinity for Back-Rinse Solvent>

The affinity of the photosensitive resin compositions of Examples 1 and Comparative Examples 1 to 3 obtained above for the back-rinse solvent was evaluated by the following procedure. Comparative Example 4 in which the polyether-modified polydimethylsiloxane and the fluorine-based surfactant had not been added was also evaluated. Furthermore, the composition of Comparative Example 4 was the same as in Example 1, except that the polyether-modified polydimethylsiloxane 1 was not used.

The photosensitive resin composition of each example was spin-coated on a substrate so that the film thickness was 10 µm, thereby forming a coating film. About 7 mg of a back-rinse solvent (OK73 Thinner, PGME/PGMEA = 7/3, manufactured by Tokyo Ohka Kogyo Co., Ltd.) was added dropwise to a surface of the coating film from a height of 5 cm from the surface of the coating film immediately after formation using a dropper. The infiltration diameter (the diameter of a portion into which the back-rinse solvent has infiltrated) (mm) of the back-rinse solvent over the coating film immediately after the dropwise addition was measured. The results are shown in Table 2.

**[Table 2]**

| | Unit | Example 3 | Comparative Example 1 | Comparative Example 3 | Comparative Example 4 |
|---|---|---|---|---|---|
| Affinity for back-rinse solvent (infiltration diameter) | mm | 22 | 30 | 14 | 32 |

This application claims priority based on Japanese Patent Application No. 2023-055060 filed on March 30, 2023, the entire disclosure of which is herein incorporated by reference.

## Claims

1. A photosensitive resin composition comprising:
an alkali-soluble resin (A);
a polyether-modified polydimethylsiloxane (B);
a solvent (C); and
a photosensitizer (D),
wherein a polystyrene-equivalent weight-average molecular weight (Mw) of the polyether-modified polydimethylsiloxane (B), measured by gel permeation chromatography, is 1,000 or more and 5,000 or less.

2. The photosensitive resin composition according to Claim 1,
wherein the solvent (C) includes a solvent (C1), and
the solvent (C1) includes at least one selected from the group consisting of γ-butyrolactone, N-methyl-2-pyrrolidone, N-ethyl-2-pyrrolidone, propylene glycol monomethyl ether, 3-methyl-2-oxazolidinone, 3-methoxy-N,N-dimethylpropanamide, and propylene glycol monomethyl ether acetate.

3. The photosensitive resin composition according to Claim 2,
wherein a content of the solvent (C1) in the solvent (C) is 50% by mass or more and 100% by mass or less with respect to an entirety of the solvent (C).

4. The photosensitive resin composition according to any one of Claims 1 to 3,
wherein the polyether-modified polydimethylsiloxane (B) includes a polyether-modified polydimethylsiloxane, having a ratio (Mw/Mn) of a polystyrene-equivalent weight-average molecular weight (Mw) to a polystyrene-equivalent number-average molecular weight (Mn), measured by gel permeation chromatography, of 1 or more and 10 or less.

5. The photosensitive resin composition according to any one of Claims 1 to 4,
wherein the polyether-modified polydimethylsiloxane (B) includes a polyether-modified polydimethylsiloxane having a weight-average molecular weight of a maximum peak of a polystyrene-equivalent molecular weight distribution, measured by gel permeation chromatography, of 1,000 or more and 5,000 or less.

6. The photosensitive resin composition according to any one of Claims 1 to 5,
wherein a polystyrene-equivalent weight-average molecular weight (Mw) of the alkali-soluble resin (A), measured by gel permeation chromatography, is 5,000 or more and 70,000 or less.

7. The photosensitive resin composition according to any one of Claims 1 to 6,
wherein a content of the polyether-modified polydimethylsiloxane (B) is 10 ppm or more and 3,000 ppm or less with respect to an entirety of the photosensitive resin composition.

8. The photosensitive resin composition according to any one of Claims 1 to 7, further comprising:
an adhesion aid (E).

9. The photosensitive resin composition according to any one of Claims 1 to 8,
wherein the polyether-modified polydimethylsiloxane (B) includes a polyether-modified polydimethylsiloxane represented by General Formula (1), 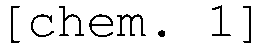 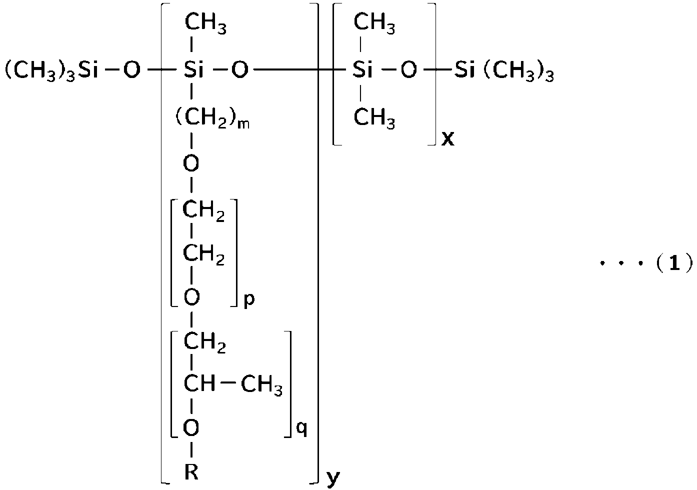
(in General Formula (1), m has an average value of 1 or more and 5 or less, p has an average value of 1 or more and 10 or less, q has an average value of 0 or more and less than 1, and R represents hydrogen or an alkyl group having 1 or more and 5 or less carbon atoms).

10. The photosensitive resin composition according to Claim 9,
wherein in General Formula (1), x has an average value of 1 or more and 50 or less, and y has an average value of 1 or more and 10 or less.

11. The photosensitive resin composition according to Claim 9 or 10,
wherein x/y in General Formula (1) is 1 or more and 5 or less.

12. A cured film obtained by curing the photosensitive resin composition according to any one of Claims 1 to 11.

13. An electronic device comprising:
the cured film according to Claim 12.

14. A method for manufacturing an electronic device, the method comprising:
a step of forming a coating film over a substrate using the photosensitive resin composition according to any one of Claims 1 to 11.

15. The method for manufacturing an electronic device according to Claim 14, the method further comprising:
a step of washing the coating film on a back side of the substrate.
